# EUROPEAN PATENT APPLICATION

(11) **EP 4 841 359 A1**
(43) Date of publication of application: **18.11.2026**
(21) Application number: 25176158.1
(22) Date of filing: 13.05.2025
(51) Int. Cl.: G03H 1/26, G03H 1/04, G01N 21/47, G02B 21/36, G03H 1/08, H10H 29/14, G02B 21/14, G03H 1/00, G02B 19/00, G02B 27/58

(54) **LENSLESS IMAGING DEVICE AND MICROSCOPE SYSTEM**

(71) Applicant: Yuri GmbH, 88074 Meckenbeuren (DE)
(72) Inventor: Kaschubek, Daniel, 88267 Vogt (DE)
(74) Representative: Kirchner, Christian

(57) **Abstract**

The invention is related to a microscope and a lensless imaging device for obtaining a hologram image, carrying intensity and phase information, of microbial specimen, in particular biological cells, in particular having a maximum measure between 15 and 120 um, contained in a culture chamber, comprising a camera sensor device having a camera sensor surface, a microLED array device having individually controllable LEDs, which are aligned along an LED array plane; a holder device for maintaining a relative position of the camera sensor device and the microLED array device, creating a receiving space between the camera sensor surface and the LED array plane, which are separated by a first distance, the receiving space being adapted to receive the culture chamber and being adapted for allowing the transmission of light, which is emitted by the microLED array device, through the receiving space and the culture chamber, an electronic control device for controlling the microLED array device and the camera sensor device and being programmed to perform an image capture process for obtaining a hologram image of the microbial specimen contained in the culture chamber, and a data storage device for storing hologram image data obtained by the camera sensor device, the hologram image data representing the hologram image.

## Description

The present invention is directed to a lensless imaging device and a microscope system including the lensless imaging device. The lensless imaging device is configured for obtaining a hologram image, carrying intensity and phase information, of microbial specimen, in particular biological cells, which in particular have a maximum measure between 5 and 120 µm, contained in a culture chamber, particularly for spaceflight application.

A lensless imaging device is known as a system designed to capture the diffraction pattern, also referred to as hologram image, of a cell sample without employing traditional optical lenses. A computer device, being part or being not part of the lensless imaging device, may then apply a computational algorithms process to raw diffraction data containing the hologram image, to reconstruct brightfield and/or phase contrast images of the sample. Essentially, the lensless imaging device facilitates the imaging of cellular structures by generating raw diffraction data that can be computationally transformed into detailed visual representations, eliminating the need for bulky optical components.

Compact devices are particularly essential for spaceflight application. Designing devices for spaceflight missions necessitates a focus on compactness and efficiency, as cargo costs are directly influenced by both volume and mass. Historically, the expense of transporting payloads to space has been substantial. For instance, NASA's Space Shuttle program incurred costs of approximately $54,500 per kilogram to Low Earth Orbit (LEO). Advancements in launch vehicle technology have led to more cost-effective solutions; SpaceX's Falcon 9 rocket, for example, offers launch costs around $2,720 per kilogram to LEO. Despite these reductions, the financial implications of transporting equipment to space remain significant. Consequently, it is imperative to engineer, for spaceflight application, a lensless imaging device that is not only lightweight but also occupies minimal space. This approach not only reduces transportation expenses but also optimizes the utilization of limited cargo capacity aboard spacecraft.

Moreover, designing a lensless imaging device for spaceflight application requires structural integrity to withstand mechanical stresses encountered during launch and operation in space. This involves compliance with structural design and test factors of safety, accounting for uncertainties in material properties, manufacturing processes, and loading conditions. The device must operate reliably under extreme temperatures, vacuum conditions, and exposure to cosmic radiation. Moreover, the structural properties of the lensless imaging device employed in space must also provide reliable operation under zero gravity and microgravity conditions. For instance, the European Cooperation for Space Standardization (ECSS) provides guidelines for the person skilled in the art on structural factors of safety for spaceflight hardware.

Designing equipment for handling, particularly, biological samples in space missions necessitates a secure deposition of biological sample containers to prevent contamination of both the spacecraft environment and the samples themselves. A secure deposition of the sample container is fundamental for maintaining appropriate environmental conditions within the containers for preserving the viability of biological samples. This includes preserving the conditions of temperature, humidity, and atmospheric composition in the container by protecting the same. Moreover, the equipment designed for handling biological samples in space laboratories must be compatible with zero-G and microgravity operations.

The **object underlying the present patent application** is to provide a lensless imaging device suitable for a spaceflight application, for obtaining a hologram image of microbial specimen, in particular biological cells in a cell culture chamber.

The present invention solves this problem by the subject matter of the independent claims. Preferred embodiments are described by the dependent claims and the present description of further optional features and advantages, including the embodiments according to the figures and their respective description.

In common usage, "lensless" microscopy means the imaging path itself does not rely on a lens (or set of lenses) to produce a magnified image directly onto a sensor. Instead, the sample is placed opposing the sensor and the resulting diffraction or hologram patterns are recorded and then computationally "refocused." This principle does not necessarily exclude all optical elements-some lensless systems may still include fixed lenses (for instance, to collimate illumination) or simple filters-but it does eliminate the need for a traditional objective lens or a movable focusing lens in the main imaging path. Hence, "lensless" basically refers to the absence of a lens-based magnification system, rather than an outright prohibition against any lens component anywhere in the setup.

In a preferred embodiment, the lensless imaging device is suitable for spaceflight applications. In addition to its lens-free design, it is preferably purpose-built to function reliably in zero-g: all components are rigidly secured by the holder device and do not depend on weight or vertical orientation for alignment, while fluid-handling systems are held firmly in position and preferably fully enclosed-preferably using microfluidic channels or sealed chambers that keep liquids stable regardless of orientation. These measures ensure consistent performance, prevent leaks or contamination, and support automated, hands-off operation during spaceflight.

By contrast, conventional apparatuses not adapted to microgravity-and whose functionality or positioning fundamentally depends on gravity-will fail once the gravitational pull is removed. Traditional microscopes, for example, often rely on gravity to maintain stable alignment of mechanical components such as sample holders, stages, or heavy assemblies. In zero-g, these parts can shift or become misaligned, causing poor or inconsistent imaging. Likewise, open fluid systems that rely on gravitational settling can experience uncontrolled floating or bubble formation, severely disrupting the sample environment. Consequently, adapting both the mechanical design and fluid-handling approach is essential for successful operation in space.

In case that the lensless imaging device is not configured for spaceflight application, the overall microscope system can be configured more flexibly with regard to different aspects like mechanical complexity, form factor and overall mass, robustness, automation capability, power consumption and fluid handling.

A primary benefit of the lensless imaging device is the compactness, which is achieved, in particular, by a receiving space for the culture chamber being located in a space saving way directly between the camera sensor surface and the LED array plane, the receiving space being in particular adjacent to, or even substantially in contact with, the camera sensor surface and the LED array plane. Positioning the culture chamber directly between the camera sensor surface and the microLED array plane minimizes the overall device footprint. This configuration eliminates the need for additional components or extended pathways, resulting in a more compact and mechanically stable system.

The receiving space for the culture chamber is defined to be the space taken up and occupied by the culture chamber, in particular a cuboidal space. Preferably there is either no distance or only a small distance between the camera surface and the receiving space, or between the camera surface and the culture chamber when the latter is inserted into the receiving space. Similarly, there is preferably either no distance or only a small distance between the LED array plane and the receiving space, or between the LED array plane and the culture chamber when the latter is inserted into the receiving space. The distance is in particular smaller than the thickness of a flat culture chamber, "flat" meaning that the height of the culture chamber is lower than the length or width thereof.

The design specifies minimal or no distance between the camera sensor surface, the receiving space, and the LED array plane. This close proximity reduces the overall device thickness and enhances structural integrity by minimizing cantilevered parts or extended structures that could be susceptible to mechanical stress.

Space missions, in particular, are constrained by strict limitations on payload size and weight, and eliminating bulky lenses and reducing dimensions of the lensless imaging device results in a lighter, more compact system. This reduction not only lowers launch costs but also optimizes the utilization of limited space aboard spacecraft. This advantage is also useful for non-spaceflight applications.

### Holder device, main features

The holder device for maintaining a relative position of the camera sensor device and the microLED array device, thereby creating the receiving space, results in a layer wise construction of the lensless imaging device, which provides optimal structure with regard to mechanical simplicity and durability. By securing the camera sensor and microLED array in fixed positions, the holder device ensures that the optical path remains consistent. This rigidity is beneficial for reliable operation, especially in harsh conditions like during spaceflight missions, where mechanical simplicity and durability are paramount.

The planar, layered structures are inherently stable and resistant to bending or torsional stresses. With a planar alignment of the basic components, no or few moving parts and no need for mechanical focusing systems, the lensless imaging device is less susceptible to failure or the need for maintenance. The robustness reduces the risk of malfunctions due to vibrations during launch or challenges posed by microgravity, ensuring reliable operation throughout the mission.

By incorporating a layered structure, the lensless imaging device leverages these mechanical advantages, resulting in a robust and durable system well-suited for the demanding conditions of space missions: the layered configuration effectively distributes mechanical loads across multiple interfaces. This distribution reduces stress concentrations, minimizing the risk of structural failure. Such an arrangement enhances mechanical performance by mitigating localized stress. Each layer can absorb and dissipate energy from mechanical shocks or vibrations. This capacity is particularly beneficial in the space environment, where equipment is subject to significant vibrational forces during launch and operation. Layered designs can accommodate differential thermal expansion between materials, reducing the likelihood of warping or structural damage due to temperature fluctuations. This adaptability is crucial in space, where equipment experiences extreme temperature variations.

The lensless imaging device is also inherently less sensitive to microgravity effects, which can adversely affect traditional optical systems by causing alignment, focusing issues and maladjustment of parts caused by changes of gravity. By relying on diffraction patterns rather than precise lens arrangements, as well as by providing an intrinsically stable structure, the lensless imaging device maintains stable performance regardless of the gravitational environment. This stability is essential for consistent imaging results during space missions.

The lensless imaging device does not require performing the computational algorithms process, which is used for extracting a brightfield image and/or a phase contrast image from the hologram image. In such a case, the computing power of the lensless imaging device and therefore, the consumption of energy and the production of waste heat can be reduced or avoided. Using the lensless imaging device offers significant advantages when energy availability and heat dissipation paths are limited. This is the case, particularly, for applications located in space or applied under artificial microgravity conditions.

Energy efficiency is another significant advantage of the lensless imaging device. The absence of active focusing mechanisms and fewer components result in lower power consumption-a critical factor given the limited power resources available in space. This efficiency allows for longer operational periods and conserves energy for other vital systems on the spacecraft.

The ability to offload computational processing to a remote workstation minimizes the need for heavy onboard computational resources. By transmitting diffraction pattern data to a remote workstation, in particular to Earth, the device leverages advanced reconstruction capabilities without burdening the carrier of the lensless imaging device, in particular a spacecraft, with powerful processors. This approach may take advantage of superior ground-based computational infrastructure to generate high-quality brightfield and phase contrast images from the raw data collected in space. However, in a preferred embodiment of the lensless imaging device, a sufficiently powerful computing device may be included for performing the post-processing of hologram images.

The lensless imaging device offers versatility in imaging, as the same diffraction data can be used to reconstruct different types of images without changing hardware components. This flexibility is particularly advantageous in space missions, where adaptability to various experimental needs is essential and hardware modifications are impractical.

A wide depth of field is an inherent feature of the lensless system, accommodating slight movements or positioning errors of cell samples. In microgravity conditions, controlling precise positions can be challenging; thus, this characteristic ensures effective imaging despite such difficulties. The reduced need for calibration and less frequent adjustments simplify the operation of the device in an environment where maintenance is difficult.

Enhanced safety and reliability are further benefits. With fewer mechanical parts, there are fewer potential points of failure that could release contaminants into the spacecraft environment. The increased reliability of the system is important in space missions where repair opportunities are limited and equipment failure can have severe consequences.

From a research perspective, the lensless imaging device facilitates biological studies by enabling real-time monitoring of cellular processes affected by microgravity. It provides valuable data to space biology and medicine without interfering with delicate biological experiments. The non-invasive nature of the imaging reduces disturbance to samples, preserving their integrity for accurate analysis.

Data transmission efficiency is improved, as diffraction pattern data may be more compact than full image data, making it more efficient to transmit to a remote workstation, in particular back to Earth. This efficiency is important given the bandwidth limitations and communication delays inherent in space missions.

Finally, the lensless imaging device is cost-effective. The simpler design and reduced complexity lower the costs associated with producing specialized space-grade imaging equipment. This economic advantage allows for the allocation of resources to other critical areas of the mission.

Preferably, the first distance d1 between the camera sensor surface and the microLED array plane is between 5.0 mm and 20.0 mm, more preferably between 6.0 mm and 15.0 mm, and even more preferably between 8.0 mm and 12.0 mm. This has multiple technical effects that enhance the performance, reliability, and manufacturability of the lensless imaging device. These effects include optimizing the balance between resolution and field of view, enhancing image reconstruction capabilities, controlling wavefront properties, maintaining coherent illumination conditions, contributing to compactness and structural stability, aiding thermal management, simplifying manufacturing, optimizing the optical path length, ensuring compatibility with biological samples, and facilitating the effectiveness of phase retrieval algorithms. Within the specific preferred ranges of the first distance, the device can achieve high-quality imaging while maintaining a compact and robust design suitable for challenging environments:
Firstly, setting the first distance within these specific ranges optimizes the balance between resolution and field of view (FoV) in the imaging system. In lensless imaging systems utilizing spherical wave illumination from point light sources like microLEDs, the first distance directly influences the magnification factor. By carefully selecting this distance, it is ensured that the distances from the light source to the sample (Z) and from the sample to the camera sensor (z) are proportioned to achieve a desirable magnification. This balance allows the device to meet required imaging specifications, such as achieving a resolution of 3 µm with a FoV of 30 mm². Shorter distances can increase magnification and potentially improve resolution while reducing the FoV, whereas longer distances can expand the FoV at the expense of resolution. The preferred ranges represent an optimal compromise between these factors. Preferably, the lensless imaging device is configured to provide a field of view (FoV) taken from the preferred range 5.0 mm² <= FoV <= 200 mm², the preferred range 5.0 mm² <= FoV <= 100 mm², or the preferred range 10.0 mm² <= FoV <= 35.0 mm².

Secondly, specifying the first distance enhances the effectiveness of image reconstruction and phase retrieval algorithms used in the device. Proper separation between the microLED array and the camera sensor ensures that the captured diffraction patterns possess sufficient spatial frequencies and interference fringes necessary for accurate image reconstruction. Distances within the specified ranges facilitate the necessary oversampling required by algorithms like the Ptychographic Iterative Engine (PIE) and its variants. This optimization is crucial for retrieving both amplitude and phase information from the sample, resulting in high-quality quantitative phase contrast images.

Thirdly, the specified distance allows for better control over the spherical wavefront properties of the emitted light. By selecting appropriate distances Z and z, one can manipulate the numerical aperture (NA) and thus the system's resolution, leveraging the benefits of spherical wave illumination. This control enables the device to achieve resolutions better than what would be possible with planar illumination at the same distances. The magnification effect introduced by spherical wavefronts from point sources is directly influenced by the first distance, affecting the system's ability to resolve fine details in the sample.

Moreover, maintaining the first distance within these ranges helps preserve the necessary coherence length and illumination conditions required for holographic imaging. The microLEDs act as quasi-point sources, and their effective coherence depends on the distances involved. Appropriate spacing ensures that the coherence properties are suitable for producing clear and distinguishable diffraction patterns, which are essential for capturing high-contrast holograms that can be accurately reconstructed.

Additionally, the specified distance contributes significantly to the device's compactness and structural stability. The distances are minimal enough to keep the device slim and suitable for space-constrained applications-such as those found in space missions-yet large enough to prevent mechanical interference between components. A first distance between 6.0 mm and 15.0 mm provides an optimal balance, allowing for a thin culture chamber while maintaining enough separation to prevent physical contact between the microLEDs and the sample or between the sample and the camera sensor. This careful spacing enhances the mechanical integrity of the device, reducing the risk of damage due to vibrations or shocks and ensuring reliable operation in harsh environments.

Furthermore, appropriate spacing helps with thermal management by preventing thermal crosstalk between the microLED array and the camera sensor, via the receiving space and the culture chamber. MicroLEDs can generate heat during operation, and maintaining the first distance within the specified ranges ensures that the heat generated does not adversely affect the camera sensor's performance. Adequate spacing allows for natural convection or the integration of thermal management solutions without significantly increasing the device size, thereby maintaining the device's compactness.

Specifying the first distance also simplifies the manufacturing and assembly process. Standardizing the distance within these ranges allows for tolerances that are achievable with standard manufacturing techniques. It ensures that the culture chamber fits precisely within the receiving space, facilitating easy assembly and replacement if necessary. This standardization contributes to consistent production quality and reduces the likelihood of assembly errors that could affect device performance.

Optimizing the optical path length is another technical effect of specifying the first distance. In the lensless imaging device, the optical path length affects the phase accumulation and the resulting interference patterns. Distances within the specified ranges ensure that the optical path length is suitable for the wavelengths used (e.g., the microLED emission wavelength), minimizing phase errors and aberrations. This optimization enhances image quality by reducing distortions that could compromise the accuracy of the reconstructed images.

Compatibility with biological samples is also ensured by accommodating the physical dimensions of the culture chamber and the biological specimens contained within. The specified first distance ensures that the culture chamber can house the samples adequately without compression or undue stress while still fitting within the device's optical configuration. This is particularly important when imaging live specimens, as maintaining their integrity is crucial for obtaining accurate and meaningful results.

Lastly, the specified distance facilitates oversampling for phase retrieval by allowing sufficient spatial shifting of the illumination pattern across the sample. Appropriate first distance enables the microLED array to illuminate the sample from slightly different angles or positions, providing the multiple intensity measurements needed for accurate phase retrieval. This is essential for quantitative phase contrast imaging, as it allows for the reconstruction of phase information that is not directly captured by intensity measurements alone. The ability to retrieve phase information enhances the device's imaging capabilities, enabling detailed analysis of transparent or semi-transparent biological samples.

In summary, the first distance is chosen to be within the ranges of 5.0 mm to 20.0 mm, preferably 6.0 mm to 15.0 mm, and more preferably 8.0 mm to 12.0 mm. This has multiple technical effects that enhance the performance, reliability, and manufacturability of the lensless imaging device. These effects include optimizing the balance between resolution and field of view, enhancing image reconstruction capabilities, controlling wavefront properties, maintaining coherent illumination conditions, contributing to compactness and structural stability, aiding thermal management, simplifying manufacturing, optimizing the optical path length, ensuring compatibility with biological samples, and facilitating the effectiveness of phase retrieval algorithms. By carefully selecting this critical distance, the device can achieve high-quality imaging while maintaining a compact and robust design suitable for challenging environments.

### Holder device embodiments

The holder device is designed to maintain the precise and stable positioning of the camera sensor device, the microLED array device, and the culture chamber within the receiving space. The structural integrity and optical performance of the imaging device are dependent on a reliable and precise functioning of the holder device. The holder device comprises or is preferably constructed from one or more lightweight yet durable high-strength materials such as aluminum alloy or polymer.

In one preferred embodiment, the holder device comprises a rigid frame assembly or rack assembly. This frame assembly securely holds the camera sensor device and the microLED array device in fixed positions, ensuring parallel alignment of their respective planes. The holder device preferably includes a slot or one or more guide elements that allows the insertion and secure placement of the culture chamber within the receiving space between the camera sensor surface and the microLED array plane, within the slot and/or guided by the guide elements.

The holder device may be or may comprise a slot device, which contains a slot, which provides the receiving space. The slot allows for inserting the culture chamber in the receiving space. Preferably, the slot device provides two opposing main sides or main walls, each main side or main wall having a window. Preferably, the camera sensor surface is aligned at one of said windows and the microLED array plane is arranged at the opposing window, such that the camera sensor surface and the microLED array plane are facing each other, separated by the slot or respectively the receiving space. The windows allow forming the optical paths for obtaining the hologram image(s) of the samples in the culture chamber by capturing the light being transmitted along said optical paths.

The opposing main sides or main walls of the slot device are connected by connection elements, for example side walls or side elements. The connection elements and the main sides/walls may be separated components, which are fastened to each other using fastening means, or may be, at least partly, be integrally formed. The culture chamber preferably fits into a designated slot within the frame, which may include cushioning elements or gaskets to provide a snug fit and minimize movement. This embodiment ensures precise optical alignment, contributing to consistent imaging performance and the effectiveness of image reconstruction algorithms.

The holder device may employ one or more mechanical fastening means such as screws, clamps, or interlocking components to fix the imaging devices to the frame, enhancing structural stability and resistance to mechanical stresses and vibrations.

Another preferred embodiment involves the direct fixation of the culture chamber to the camera sensor device and/or to the microLED array device without the use of an intermediary frame for holding the culture chamber. This can be achieved using optically clear, biocompatible adhesives that bond the culture chamber to the adjacent devices, or through mechanical fasteners such as small screws, clips, or clamps integrated into the housings of the camera sensor device and/or to the microLED array device. This embodiment reduces the overall size of the lensless imaging device by reducing holding structures, contributing to its compactness. Direct attachment minimizes the number of interfaces and potential points of mechanical failure, enhancing structural stability. Additionally, it reduces air gaps between components, minimizing light scattering and improving image quality. The integration of the culture chamber into the imaging device simplifies assembly and maintenance, as fewer parts are involved.

In a further embodiment, the holder device is configured to create a snug fit connection for the culture chamber within the receiving space. The receiving space is precisely dimensioned to match the external dimensions of the culture chamber, allowing it to fit tightly between the camera sensor surface and the microLED array plane. Precision manufacturing techniques ensure tight tolerances for an exact fit, while elastomeric linings or gaskets may be incorporated to accommodate slight variations and provide cushioning. Guided insertion features such as alignment pins or rails can be included to facilitate smooth and accurate placement of the culture chamber. This snug fit connection ensures consistent optical paths and maintains the required minimal distances between components, which is essential for accurate imaging and reconstruction. It also enhances ease of use by allowing quick insertion and removal of the culture chamber without the need for tools, and reduces the risk of contaminants entering the optical path. The holder device and/or the culture chamber may comprise snap-on means for implementing a reversible or irreversible snap-on connection.

An alternative embodiment combines the advantages of both a rigid frame assembly and direct fixation methods. In this design, a frame assembly or rack assembly provides overall structural integrity and maintains the fixed positions of the camera sensor device and the microLED array device. The culture chamber is then directly attached to one or both devices within the frame using adhesives or mechanical fastening means. The frame assembly may include integrated features such as mounting points or adhesive channels that facilitate this direct attachment. This combined approach enhances stability by utilizing the rigidity of the frame and the security of direct attachment. It allows for modularity, enabling individual components to be replaced or serviced without affecting the entire assembly. The precise alignment and secure holding improve imaging accuracy and contribute to the lensless imaging device's reliability in various operating conditions.

Another embodiment features adjustable clamping mechanisms incorporated into the holder device to secure the culture chamber. These mechanisms can include springloaded clips, thumb screws, or lever clamps that apply consistent pressure to hold the culture chamber firmly in place. The clamps can be designed to accommodate slight variations in the culture chamber's dimensions, providing flexibility and adaptability. This design enhances ease of access, simplifying the process of inserting or removing the culture chamber, which is particularly beneficial for applications requiring frequent sample changes. The adjustable clamps maintain stable positioning of the culture chamber even under environmental stresses such as vibrations or temperature fluctuations. The consistent pressure ensures that the optical distances remain constant, preserving imaging performance.

In a further embodiment, the holder device comprises a magnetic attachment system to secure the culture chamber. Preferably, one or more magnets, in particular permanent magnets, are connected to or embedded into the holder device and the culture chamber, creating a magnetic force that holds the culture chamber in the correct position. The magnetic fields can be designed to assist in aligning the culture chamber during insertion, enhancing ease of assembly. This non-intrusive holding method avoids or reduces physical clamps or fastening means that might obstruct the optical paths, contributing to the compactness of the device. The magnetic attraction provides a secure yet releasable connection, simplifying maintenance and sample replacement. Additionally, the slight give in the magnetic attachment can absorb minor shocks or vibrations, reducing potential damage to the components.

An embodiment employing elastic or flexible holding elements involves using materials such as silicone sleeves, rubber gaskets, or flexible arms to secure the culture chamber within the receiving space. These elements grip the culture chamber securely while accommodating minor dimensional variations due to manufacturing tolerances or thermal expansion. The flexible materials provide vibration isolation, enhancing image stability by dampening external mechanical disturbances. This design also simplifies the insertion and removal process, as the elastic elements can flex to accommodate the culture chamber without the need for adjustments or tools. The use of biocompatible and sterilizable materials ensures compatibility with biological samples and sterilization processes.

Another preferred embodiment may feature an integrated slot or drawer mechanism within the holder device. The culture chamber is placed on a sliding tray or inserted into a slot that guides it into the correct position between the camera sensor device and the microLED array device. A locking mechanism, such as a latch or magnetic catch, may be provided to secure the culture chamber once inserted. This design facilitates quick and straightforward loading and unloading of samples, enhancing user-friendliness. The guided rails ensure precise alignment of the culture chamber during insertion, maintaining consistent optical paths. When closed, the slot or drawer provides a protected environment for the culture chamber, shielding it from external contaminants and mechanical damage.

By securely maintaining the positions of the imaging components and the culture chamber, the holder device enhances the structural integrity of the lensless imaging device. This is particularly important in environments subject to mechanical stresses or vibrations, such as during space missions. The embodiments of the holder device aim to minimize the overall size of the device by eliminating unnecessary components and optimizing the spatial arrangement of the existing ones. Compactness is achieved through direct attachment methods, snug fit connections, and the integration of holding mechanisms within the device's structure. Maintaining consistent distances and alignment between the camera sensor device, the microLED array device, and the culture chamber is essential for accurate imaging and the effectiveness of phase retrieval algorithms. The holder device embodiments ensure that these components remain in the correct positions during operation. The preferred embodiments facilitate straightforward assembly and disassembly of the device, allowing for easy maintenance, replacement of components, or insertion of new culture chambers. Features such as adjustable clamps, magnetic attachments, and integrated slots enhance user-friendliness. By securely holding the culture chamber and shielding sensitive components from external factors, the holder device contributes to the longevity and reliability of the lensless imaging device. It reduces the risk of contamination, mechanical damage, and misalignment. The holder device designs consider the need for sterilization, biocompatibility, and avoidance of contamination, ensuring that the imaging device is suitable for use with live biological specimens.

### MicroLED Array Device

The microLED array device serves as the illumination source that enables high-resolution imaging and effective phase retrieval.

The electronic control device is configured, in particular programmed, to individually control one or more, or all of the individually controllable microLEDs of the microLED array device, in particular control the on/off phases of each LED, the intensity of light emitted by each LED, and/or the time of activity of each LED.

Preferably, a microLED array of the microLED array device has a LED pitch "PL" being a center-to-center distance of adjacent microLEDs of the microLED array. Preferably, an LED pitch PL of the microLED array is chosen from the preferred range 1.0 µm <= PL <= 50 µm, the preferred range 5.0 µm <= PL <= 30 µm, or the preferred range 5.0 µm <= PL <= 12 µm. Such ranges for PL provide significant technical effects on the performance, resolution, field of view, and overall design of the lensless imaging device. Such a choice of LED pitch positively influences the spatial sampling of the illumination, guarantees a preferred effectiveness of optional phase retrieval algorithms, and provides balance between resolution and field of view. Such pitches also contribute to a simplified manufacturability of the microLED array.

Firstly, the LED pitch determines the spatial diversity of the illumination patterns across the sample. A smaller LED pitch, particularly within the range of 5.0 µm to 12.0 µm, allows for a denser arrangement of microLEDs, resulting in finer spatial shifts in the illumination. This fine control over the illumination positions enhances the oversampling necessary for effective phase retrieval. The increased number of unique illumination angles improves the ability of algorithms like coded ptychography to reconstruct high-resolution images by capturing more comprehensive spatial frequency information from the sample.

Specifically, when the LED pitch is small, the illumination patterns overlap significantly, providing high redundancy in the captured data. This redundancy is beneficial for phase retrieval algorithms, as it enhances the robustness of the reconstruction process against noise and artifacts. It allows the system to resolve finer details in the sample, improving the resolution of the imaging device. Therefore, specifying the LED pitch within the preferred smaller ranges directly contributes to achieving the desired resolution of 3 µm or better, as preferred for imaging applications involving fine biological structures.

Moreover, the LED pitch affects the balance between resolution and field of view (FoV). A smaller LED pitch increases the resolution but may reduce the effective FoV due to the magnification effects inherent in lensless imaging systems using point sources of light. Conversely, a larger LED pitch, such as in the broader range of 1.0 µm to 50 µm, increases the FoV but may compromise the resolution due to less dense sampling of the illumination positions. By specifying the LED pitch within the more preferred ranges, the device achieves an optimal balance where the resolution is enhanced without excessively limiting the FoV. This balance is preferred for applications where both high resolution and a sufficiently large FoV are necessary to capture meaningful data from the sample.

Furthermore, the LED pitch impacts the manufacturability and reliability of the microLED array. By specifying the LED pitch within the preferred range of 5.0 µm to 12.0 µm, the design remains within the capabilities of established microfabrication processes, ensuring that the microLED arrays can be produced reliably and at a reasonable cost.

Additionally, a pitch within the preferred ranges allows for adequate space between microLEDs to route electrical connections without being faced with problems of crosstalk, which is beneficial for individually addressing each microLED. It simplifies the PCB design and reduces the complexity of the control electronics, contributing to the overall compactness and robustness of the lensless imaging device. Moreover, the LED pitch influences the thermal management of the microLED array. By selecting an LED pitch within the preferred ranges, sufficient spacing between microLEDs is maintained to allow for effective thermal dissipation, preventing overheating and ensuring stable operation.

A smaller pitch PL enables the microLEDs to illuminate the sample from positions that are more closely spaced, providing finer spatial increments. This enhances the positional sampling of the scattered light from the sample, which is beneficial for reconstructing high-resolution images, especially in the context of holographic and phase contrast imaging.

Furthermore, specifying the LED pitch within these ranges allows for compatibility with the pixel size of the camera sensor. For effective super-resolution and phase retrieval, the spatial shifts introduced by different microLED positions need to be resolved by the sensor. If the LED pitch is too small relative to the sensor pixel size, the shifts may not be adequately captured, reducing the effectiveness of the imaging system. By aligning the LED pitch with the sensor's resolution capabilities, the system ensures that the spatial information introduced by the microLED array is fully utilized.

Preferably, the microLED array comprises or is a -preferably **complete- rectangular array of microLEDs,** also referred to as microLED matrix, the microLED matrix having n rows and p columns forming an n × p matrix, having a microLED preferably at each grid point of the matrix, the microLED matrix having an LED pitch PL.

The complete microLED matrix provides uniform and comprehensive coverage of the illumination area. By having a microLED at each grid point, the array enables precise and systematic control over the illumination patterns across the entire sample. This dense and regular arrangement enhances spatial diversity in the illumination, which is beneficial for effective phase retrieval algorithms like coded ptychography. The increased number of unique illumination positions improves the sampling of spatial frequencies, leading to higher-resolution images and improved reconstruction quality. The rectangular matrix configuration simplifies the control electronics and software algorithms required to operate the microLED array. The regular grid pattern aligns with standard addressing schemes used in electronics, allowing for efficient multiplexing and scanning of the microLEDs. The uniform LED pitch PL across the matrix ensures consistent illumination conditions, which is beneficial for quantitative imaging and accurate phase retrieval. The consistent spacing allows for precise modeling of the illumination patterns and their interaction with the sample. This uniformity enhances the predictability and repeatability of the imaging process, enabling the application of advanced computational imaging techniques and algorithms that rely on consistent input data.

Furthermore, the complete microLED matrix enhances the device's adaptability and versatility. By having microLEDs at every grid point, the system can generate a wide range of illumination patterns, including custom or dynamic patterns tailored to specific samples or imaging conditions. This flexibility supports various imaging modalities, such as differential phase contrast, structured illumination microscopy, and super-resolution techniques. It allows the device to be used in diverse applications, from biological imaging to materials science. Additionally, the matrix structure improves redundancy and reliability. If individual microLEDs fail or exhibit performance variations, the dense grid ensures that the overall functionality is maintained, and the impact on image quality is minimized. This robustness is particularly important in critical applications where consistent performance is essential, such as in space missions or long-term monitoring of biological samples. Lastly, the rectangular microLED matrix with a specified LED pitch PL facilitates scalability and customization. By adjusting the number of rows n, columns p, and the LED pitch, the array can be tailored to meet specific resolution and field-of-view requirements. This scalability allows for the development of lensless imaging devices optimized for different applications without significant redesign of the core components.

Preferably, the microLED array is an incomplete rectangular array of microLEDs, the microLED matrix having n rows and p columns forming an n × p matrix, having multiple grid point of the matrix being occupied by a microLED each and having multiple void grid point of the matrix **not** being occupied by a microLED each, the microLED matrix having an LED pitch PL, the void grid points of the matrix providing a space for receiving wiring for powering the microLEDs at the occupied grid point. In particular, the incomplete rectangular array of microLEDs having microLEDs being arranged in the shape of a cross, or circular, or ellipsoidal ring. These patterns enhance the spatial diversity of illumination for effective phase retrieval and facilitate wiring schemes. The void areas allow for the accommodation of conductive traces and bonding pads, simplifying the manufacturing process and reducing the risk of electrical shorts between closely spaced microLEDs. Additionally, such designs enhance the reliability and performance of the microLED array by allowing higher microLED densities in the occupied areas without the constraints imposed by wiring space, leading to improved resolution and overall effectiveness of the lensless imaging device.

Preferably, the center-to-center distance LDmax of the outermost microLEDs of a row or a column of the microLED matrix is chosen from the preferred range 30.0 µm <= LDmax <= 500 µm, the preferred range 60.0 µm <= LDmax <= 300 µm, the preferred range 100.0 µm <= LDmax <= 200 µm, or the preferred range 120.0 µm <= LDmax <= 160 µm. Herein, in particular, LDmax = n * PL or LDmax = p * PL. By selecting LDmax within these ranges, the overall size of the microLED array is optimized to match the desired field of view (FoV) and resolution requirements of the imaging system. A controlled LDmax ensures that the outermost microLEDs provide sufficient positional diversity in illumination across the sample. This diversity is beneficial for capturing the necessary spatial frequency information for effective phase retrieval algorithms, enhancing image resolution and quality without unnecessarily increasing the array's size.

Furthermore, specifying LDmax within these preferred ranges balances the need for extensive illumination coverage with practical considerations of manufacturability and electronic design. If LDmax is too large, the array becomes physically larger, increasing complexity, power consumption, and potentially compromising the device's compactness. Conversely, if LDmax is too small, the positional displacements of the illumination may be insufficient, limiting the effectiveness of the imaging process. Additionally, maintaining LDmax within these ranges facilitates efficient wiring and signal synchronization across the microLED array. It ensures that electrical connections can be routed without excessive congestion or interference, enhancing the reliability and performance of the device. The specified LDmax also aligns the array dimensions with the camera sensor and sample area, allowing for precise alignment and integration within the lensless imaging device.

In one preferred embodiment, the microLED array device features a cross-shaped arrangement of individually controllable microLEDs. This array preferably includes 24 to 256 microLEDs, preferably 128 microLEDs. Each microLED may be approximately 2 to 15 µm, preferably 5 µm in size. The cross-shaped pattern was found beneficial based on extensive testing and simulations, demonstrating optimal image quality and resolution for phase contrast imaging. The microLEDs are arranged with a specific pixel pitch designed to achieve the necessary spatial shifting required for coded ptychography reconstruction. The pixel pitch balances the overlap of illuminated areas and the required resolution, ensuring that the illumination covers the sample effectively without redundant overlap.

A multitude of microLEDs, preferably each microLED in the array, is preferably individually addressable, allowing precise control over the illumination sequence. This enables the capture of multiple images with varying illumination conditions, essential for oversampling and effective phase retrieval algorithms. An incomplete rectangular array of microLEDs, in particular a cross-shaped, circular or ellipsoid pattern, provides an optimal number of illumination positions while minimizing the total number of microLEDs required, enhancing the efficiency of phase retrieval and improving image reconstruction quality. Additionally, this configuration is conducive to manufacturing constraints, facilitating feasible routing of electrical connections and contributing to the device's compactness.

Another preferred embodiment involves a matrix-style microLED array with a specific pixel pitch optimized for resolution and field of view. In this design, the microLEDs are arranged in a square matrix grid, with equal spacing in both horizontal and vertical directions. The microLEDs are preferably 2 to 15 µm, preferably 5 µm in size, with a pixel pitch ranging from 2 µm to 14 µm. This spacing results from optimizing the trade-off between resolution, field of view, and manufacturability. The matrix pattern enables a high degree of spatial diversity in illumination, which improves the resolution of the reconstructed images through effective phase retrieval. The design also allows for scalability, enabling larger arrays if higher resolution or larger fields of view are desired in future implementations.

A further embodiment features a circular arrangement of microLEDs, either in concentric circles or a spiral pattern. This configuration aims to provide uniform illumination coverage and maximize the number of unique illumination angles relative to the sample. MicroLEDs of 2 to 15 µm, preferably 5 µm in size are preferably used, with careful control over the spacing between them to ensure manufacturability and optimal illumination overlap. The circular pattern offers a uniform distribution of illumination directions, enhancing the phase retrieval process and improving image quality. This design may be particularly suitable for applications where symmetry and uniformity are desired.

In an embodiment focused on achieving super-resolution imaging capabilities, the microLED array features a high-density arrangement with microLEDs smaller than 5 µm, potentially down to 1 µm. This requires advanced fabrication techniques and may involve higher operational voltages due to the reduced size of the microLEDs. The microLEDs are placed with minimal spacing, creating a high-density array that provides a significant number of unique illumination points. The small size and high density of the microLEDs enable imaging beyond the diffraction limit, achieving resolutions better than 1 µm. While this embodiment presents manufacturing and operational challenges, it pushes the boundaries of imaging performance and may be suitable for specialized applications requiring ultra-high resolution.

Another preferred embodiment includes a programmable microLED array where the intensity of each microLED can be individually controlled, not just turned on or off. The microLEDs are preferably connected to driver circuits capable of modulating the current supplied to each LED, thus controlling their brightness levels. Software algorithms, preferably, manage optional illumination patterns and intensities to optimize the phase retrieval process. This variable intensity control allows for customized illumination profiles, improving the contrast and quality of images for different types of samples. The system can implement adaptive illumination strategies, such as optimizing illumination patterns in real-time based on preliminary imaging results.

In a further embodiment, the microLED array includes integrated optical elements such as microlenses or diffractive optical elements to shape and direct the emitted light more precisely. Small lenses are fabricated directly over each microLED to collimate or focus the light, enhancing control over the illumination pattern. These integrated optical elements enhance the directionality and shape of the emitted light, contributing to better illumination uniformity and diversity. By controlling the wavefront of the illumination, the imaging system can achieve higher resolution and contrast, improving the effectiveness of phase retrieval while maintaining the device's compactness.

A modular approach to the microLED array allows for easy replacement or customization of the array for different applications. The microLED array is designed as a removable module that can be swapped out with arrays of different configurations or specifications.

Electrical and mechanical interfaces are standardized to allow compatibility with various array modules. This modular design enables the imaging device to be adapted for a wide range of applications without requiring a complete redesign. It also allows for ease of maintenance and upgrades, as damaged arrays can be easily replaced, and new technologies can be incorporated by swapping modules.

To address thermal issues associated with microLED operation, one embodiment incorporates heat management features into the array design. A printed circuit board (PCB) preferably includes thermal vias and heat sinks to dissipate heat away from the microLEDs. Preferably, high thermal conductivity materials are used for the PCB substrate and components to enhance heat dissipation.. Preferably, temperature sensors are provided monitor the microLED array's temperature, allowing for dynamic adjustments to prevent overheating. Effective heat management ensures consistent performance of the microLEDs, maintaining illumination intensity and lifespan, and enhances the system's reliability.

### LED characteristics; Preferred Embodiments Regarding the Spectrum, Output Power, and Switching Time of the MicroLEDs

The **term** "**microLED**" typically refers to LEDs that are on a microscale. The present invention uses the conventional definition of a microLED being an LED that has a luminous width of less than -or equal to- 50 µm, in particular of less than -or equal to- 20 µm, or a luminous area of less than 0.003 mm².

Preferably, a width w of the microLED is between 0.5 µm and 10 µm, preferably 0.8 µm <= w <= 8.0 µm, preferably 1.0 µm <= w <= 6.0 µm. Selecting the microLED width within these ranges allows the LEDs to closely approximate point light sources, which is essential for generating spherical wavefronts necessary in lensless holographic imaging and effective phase retrieval. A microLED width of approximately 5 µm strikes an optimal balance between achieving sufficient luminosity and maintaining manufacturability. Smaller microLEDs, such as those around 1 µm, can be challenging to fabricate and may require higher operating voltages or produce lower light output, potentially affecting image quality and device efficiency. Conversely, larger microLEDs may not approximate point sources effectively, leading to less accurate imaging and reduced resolution. Therefore, selecting a microLED width of approximately between 0.5 µm and 10 µm, preferably 5 µm, enhances the device's resolution and imaging performance while ensuring practical fabrication, sufficient light intensity, and efficient power consumption, contributing to the overall effectiveness and reliability of the lensless imaging system.

The performance of the lensless imaging device is influenced by the characteristics of the light emitted by the microLED array, including the spectrum of the emitted light, the output power of the LEDs, and their switching times. These parameters affect image quality, resolution, and the effectiveness of phase retrieval algorithms.

In one preferred embodiment, the microLED array emits light in the visible spectrum, specifically in the blue to green wavelength range of approximately 450 nm to 550 nm. Selecting LEDs that emit at shorter wavelengths within the visible spectrum has several technical advantages. Firstly, utilizing shorter wavelengths, such as blue light around 450 nm, enhances the system's resolving power according to the Rayleigh criterion, allowing it to distinguish finer details in the sample. This improvement in resolution is crucial for applications requiring high-detail imaging, such as cellular or sub-cellular structure visualization. Shorter wavelengths also improve the spatial frequency content of the captured diffraction patterns, which benefits the phase retrieval algorithms by providing more detailed information about the sample. Enhanced spatial frequencies contribute to more accurate and robust reconstruction of both amplitude and phase information, leading to higher-quality quantitative phase contrast images. Moreover, the preferred wavelength range is suitable for imaging biological specimens without causing significant photodamage or photobleaching. Blue to green light at moderate intensities is generally well-tolerated by live cells and tissues, making it suitable for imaging sensitive biological materials over extended periods. This is particularly important when monitoring dynamic biological processes or conducting time-lapse studies where sample viability must be maintained.

Alternatively, in another embodiment, the microLED array emits light in the near-infrared (NIR) spectrum, approximately 700 nm to 900 nm. This embodiment is particularly advantageous for imaging thicker biological samples or materials that are more transparent to NIR light. NIR light penetrates deeper into biological tissues due to reduced absorption and scattering, allowing for imaging of structures beneath the surface layer. Additionally, longer wavelengths experience less scattering in biological tissues, resulting in clearer images with less haze or blurring, which enhances image quality in samples where depth penetration is critical. Furthermore, NIR light generally causes less phototoxicity and photodamage, making it suitable for prolonged imaging sessions with live specimens. This wavelength range is also compatible with certain fluorescent probes and labels, expanding the imaging device's capabilities to include fluorescence imaging modalities.

In a further embodiment, the microLED array is designed to emit broadband white light or multiple discrete wavelengths using different LED types within the same array. Broadband or multi-wavelength illumination enables the capture of images at different wavelengths, which can be used to enhance contrast or provide spectral information about the sample. Employing multiple wavelengths allows for chromatic phase retrieval techniques, improving the robustness and accuracy of phase reconstruction by utilizing wavelength-dependent optical properties of the sample.

The ability to select different wavelengths makes the imaging system adaptable to various types of samples and imaging requirements. For instance, certain biological structures may exhibit better contrast at specific wavelengths, or multi-wavelength imaging may be required to differentiate between different components within a sample. This embodiment enhances the versatility of the imaging device, allowing it to be customized for specific applications.

The output power of the microLEDs is another parameter that affects the imaging system's performance. In one embodiment, the microLEDs are configured to emit light with an optical power ranging from 1 µW to 100 µW per LED. This power range ensures that the emitted light provides sufficient intensity to produce detectable diffraction patterns on the camera sensor without necessitating excessive exposure times, which could introduce motion blur or thermal effects. Keeping the optical power within this range reduces the risk of photodamage to sensitive biological specimens, allowing for safe imaging of live cells. Lower output power minimizes the thermal load on the sample and reduces the likelihood of inducing stress responses or damaging cellular structures. Additionally, lower power consumption reduces heat generation within the microLED array itself, simplifying thermal management and maintaining the compactness of the device by eliminating the need for bulky cooling systems.

In another embodiment, the microLEDs have adjustable output power, controlled through the driving current or pulse width modulation (PWM). This allows for dynamic adjustment of the illumination intensity based on the specific requirements of the sample and imaging conditions. Adjustable power enables the system to optimize exposure levels for different samples, improving image quality by avoiding underexposure or saturation. By modulating the output power, the imaging system can capture a wider range of intensities, enhancing the dynamic range of the images and enabling better visualization of both low-contrast and high-contrast features within the same sample.

Adjusting the power output to the minimum necessary level conserves energy, which is particularly important in applications with limited power availability, such as space missions or portable field devices. Energy efficiency extends the operational time of battery-powered systems and reduces the overall energy footprint of the imaging device.

The switching time of the microLEDs is a parameter for controlling exposure time during imaging. In one embodiment, the microLEDs have fast switching capabilities, with rise and fall times less than 10 nanoseconds. The rapid switching allows for precise control over exposure times, enabling high-speed imaging applications. Fast switching permits very short exposure times, reducing motion blur when imaging dynamic samples or mitigating the effects of environmental vibrations, which is particularly important in microgravity environments or settings with mechanical disturbances.

The ability to switch the LEDs on and off rapidly enables the capture of images at high frame rates, which is beneficial for time-resolved imaging or monitoring rapid processes in biological specimens, such as cellular motility, membrane dynamics, or intracellular transport. Precise timing control allows for synchronization with the camera sensor's shutter, ensuring optimal exposure and minimizing timing errors that could degrade image quality.

In another embodiment, the microLED array is designed to support pulse illumination, where the LEDs emit light in short pulses with adjustable duration and repetition rates. Pulse illumination can improve the signal-to-noise ratio by allowing higher peak intensities without increasing the average power, which is advantageous for detecting weak signals or imaging samples with low intrinsic contrast. Short pulses reduce the total light dose delivered to the sample, minimizing phototoxic effects while still providing sufficient illumination for imaging.

Pulse illumination can be coordinated with rolling shutter readout modes of the camera sensor, reducing artifacts associated with sequential pixel readout and improving image uniformity. This synchronization enhances the compatibility of the imaging device with various camera technologies and readout schemes, expanding its applicability.

By carefully selecting the spectrum of the emitted light, optimizing the output power, and ensuring rapid switching capabilities, the microLED array device enhances the overall performance of the lensless imaging system. Appropriate wavelength selection and controlled output power ensure high-resolution images with sufficient contrast and minimal artifacts, tailored to the specific needs of the application.

The ability to adjust the spectrum and intensity of the illumination allows the imaging device to be used with a wide range of samples and imaging modalities, from live-cell imaging to materials science applications. Controlling the output power and exposure time minimizes photodamage and phototoxicity, which is critical when imaging live biological specimens and ensures that the imaging process does not adversely affect the sample.

Efficient use of power and rapid switching reduce energy consumption, which is particularly beneficial in power-constrained environments or for portable devices. Lower output power and efficient thermal design maintain the compactness of the device and prevent overheating, ensuring stable operation and prolonging the lifespan of the components.

### MicroLED board

Preferably, the microLED array device includes a MicroLED board, which serves as a carrier component in the lensless imaging device. The MicroLED board supports and electrically connects the microLED array, ensuring precise control over the illumination patterns projected onto the sample within the culture chamber. Acting as the physical substrate for the microLEDs, it provides mechanical stability and facilitates seamless integration of the microLED array into the imaging device. The board includes necessary circuitry and connections to individually address and control each microLED, allowing for complex illumination sequences useful for advanced imaging techniques such as coded ptychography and phase retrieval algorithms.

In one embodiment, the MicroLED board is designed as a custom printed circuit board (PCB) that integrates control electronics, including drivers, multiplexers, and communication interfaces. This integration reduces the need for external control modules, simplifying the system architecture and enhancing signal integrity by minimizing the distance between control circuits and the microLEDs. Consequently, the overall device compactness and reliability are improved.

Another embodiment features a high-density microLED arrangement with a small LED pitch within the preferred ranges of 5 µm to 12 µm. The MicroLED board design accommodates the close spacing of microLEDs while providing adequate wiring and electrical isolation. This configuration increases the spatial resolution of illumination patterns and enhances the effectiveness of phase retrieval algorithms, contributing to higher-quality image reconstruction.

Alternatively, the MicroLED board may have an incomplete microLED array where certain grid points are left vacant to provide space for wiring and interconnections. This design facilitates the routing of electrical connections without increasing the board size, simplifying the manufacturing process by allowing space for conductive traces, and reducing the risk of electrical shorts between closely spaced microLEDs. Such a configuration maintains the compactness of the microLED array while ensuring reliable operation.

The board can also support specialized microLED patterns, such as cross-shaped, circular, or elliptical arrangements, optimized for specific imaging techniques or sample types. These patterns provide tailored illumination profiles to enhance imaging of particular sample geometries and improve phase retrieval by offering unique angular illumination diversity. Custom board layouts accommodate these specialized patterns, contributing to the adaptability of the imaging device.

A multi-layer PCB design is another embodiment, where the MicroLED Board manages complex wiring requirements by distributing connections across multiple layers. This approach enables high-density microLED arrays without compromising wiring integrity, reduces electromagnetic interference through ground planes and shielding layers, and facilitates thermal management via internal layers designed for heat dissipation.

The MicroLED board may incorporate integrated optical elements, such as microlenses or diffusers, positioned directly above the microLEDs to shape and control the emitted light. This integration enhances the directionality and uniformity of illumination, optimizing light distribution onto the sample and improving overall imaging performance.

Thermal management features are also integral to the MicroLED board design. Incorporating one or more thermal vias, heat sinks, or utilizing materials with high thermal conductivity helps manage the heat generated by the microLEDs during operation. Effective thermal management maintains optimal operating temperatures, prevents thermal-induced performance degradation, and enhances the reliability and longevity of the imaging device.

Moreover, a modular design of the MicroLED board allows for scalability and flexibility. Multiple boards can be connected or swapped to accommodate different array sizes or configurations, providing adaptability to various applications. This modularity simplifies maintenance and upgrades, supporting both functionality and production scalability.

Advanced materials, such as flexible substrates or ceramics, can be employed in constructing the MicroLED board to meet specific requirements. Flexible substrates enable the development of conformal imaging devices that adapt to curved surfaces, while ceramic substrates offer superior thermal properties and mechanical stability. The choice of materials enhances the durability and performance of the board under diverse environmental conditions.

The term "**hologram image**" refers to the diffraction pattern, caused by illuminating an object using a lensless optical arrangement, in particular using the principles of digital in-line holography microscopy (DIHM) (cf. [RD2]). Since the diffraction pattern in such a lensless microscopy setup carries the information necessary to reconstruct both a brightfield image and phase information, it is considered a hologram image. The process of mathematically retrieving the phase and reconstructing the full image aligns closely with the principles of digital holography, where a hologram is used to encode both intensity and phase. Therefore, referring to the diffraction pattern as a hologram image in the present context of lensless microscopy is appropriate.

The wording "individually controllable LEDs" also refers to the case that multiple groups of LEDs are controlled individually, a group, for example, containing at least a number of two LEDs, the number being in particular smaller than the total number of LEDs of the microLED array.

### Camera Sensor Device and Technical Features

The camera sensor device serves for capturing the diffraction patterns generated when light emitted from the microLED array interacts with the sample within the culture chamber.

### Sensor Type and Technology

Preferably, the camera sensor device having a sensor matrix of r x s sensor pixels, having a pixel pitch PS of adjacent sensor pixels being measured center-to-center, r being chosen from the preferred range 1000 <= r <= 6000, s being chosen from the preferred range 1000 <= s <= 8000.

Preferably, the camera sensor device comprises a CMOS image sensor. In a preferred embodiment, the camera sensor device utilizes a high-resolution Complementary Metal-Oxide-Semiconductor (CMOS) image sensor, such as the Sony IMX226 sensor. This sensor features an effective pixel array of approximately 3000 × 4000 pixels with a pixel size of about 1.85 µm. The use of a CMOS sensor provides several technical advantages. Firstly, the high resolution and small pixel size enable the capture of detailed diffraction patterns essential for high-resolution image reconstruction. The sensor's high sensitivity allows for the detection of low-intensity light signals, improving the signal-to-noise ratio and overall image quality. Secondly, CMOS sensors are known for their low power consumption compared to Charge-Coupled Device (CCD) sensors, which is beneficial in applications where power availability is limited, such as in space missions or portable devices. Additionally, CMOS technology allows for faster readout speeds, enabling higher frame rates necessary for dynamic imaging or capturing multiple images in quick succession during phase retrieval processes.

CCD sensors are known for their excellent image quality and low noise characteristics. A preferred embodiment of the camera sensor device may employ a CCD sensor for applications requiring high sensitivity and uniformity. CCD sensors inherently use a global shutter mechanism, capturing the entire frame simultaneously, which is advantageous for synchronizing with the illumination from the microLED array. Their high dynamic range and low noise levels enhance the detection of weak signals in the diffraction patterns, improving image quality.

EMCCD sensors incorporate an electron multiplication register, enabling the detection of extremely low light levels, down to single-photon events. This preferred embodiment of the camera sensor device is suitable for applications where the diffraction patterns are extremely faint. EMCCDs provide ultra-high sensitivity and low noise performance, enhancing the phase retrieval process and leading to more accurate and detailed reconstructed images.

sCMOS sensors combine the advantages of CMOS and CCD technologies, offering high sensitivity, low noise, high frame rates, and large dynamic range. A preferred embodiment of the camera sensor device using an sCMOS sensor benefits from enhanced imaging performance, making it suitable for dynamic imaging applications that require capturing fast-changing diffraction patterns. The global shutter capability in some sCMOS sensors ensures synchronization with the microLED illumination.

ToF sensors measure the time it takes for light to travel to the object and back, enabling depth measurements and three-dimensional imaging. A preferred embodiment of the camera sensor device incorporating a ToF sensor provides additional depth information, enhancing the reconstruction algorithms and offering a more comprehensive understanding of the sample's structure. This is particularly useful in applications requiring 3D imaging or depth-resolved analysis.

OPD arrays utilize organic semiconducting materials to detect light, offering flexibility and the potential for large-area sensors. A preferred embodiment of the camera sensor device using OPD arrays allows for innovative device designs with flexible and thin form factors. This is beneficial for applications where the imaging device needs to conform to curved surfaces or when large-area coverage is required.

Hybrid sensors combine aspects of both CMOS and CCD technologies, leveraging the high sensitivity and low noise of CCDs with the on-chip processing and speed of CMOS. A preferred embodiment of the camera sensor device employing hybrid CMOS-CCD sensors offers improved image quality and enhanced functionality, such as on-chip image correction and compression, contributing to the overall performance of the imaging system.

### Pixel Size and Density

Adjusting the pixel size and density of the camera sensor device has technical effects on imaging performance. In one embodiment, the sensor features smaller pixels ranging from 1.0 µm to 2.0 µm. Smaller pixel sizes increase the sensor's spatial resolution, allowing it to capture finer details in the diffraction patterns. This enhancement enables the system to resolve higher spatial frequencies, improving the reconstructed image's resolution, which is particularly important in lensless imaging systems where resolution is limited by the sensor's pixel size and the system's numerical aperture. Alternatively, a sensor with larger pixels, ranging from 2.0 µm to 5.0 µm, may be used to increase the sensor's dynamic range and sensitivity. Larger pixels can capture more photons due to their greater surface area, enhancing the sensor's sensitivity in low-light conditions. This is beneficial when imaging weak signals or samples that scatter light minimally, improving the image quality in challenging imaging scenarios.

### Quantum Efficiency and Spectral Response

The quantum efficiency (QE) of the camera sensor device, which measures its ability to convert incoming photons into electrical signals, is another parameter. A preferred embodiment utilizes a sensor with high QE in the wavelength range emitted by the microLED array. A higher QE increases the sensor's sensitivity, improving the signal-to-noise ratio and enabling the detection of subtle variations in the diffraction patterns. This enhancement directly benefits the accuracy of the phase retrieval algorithms and the quality of the reconstructed images. Moreover, the spectral response of the sensor is matched to the emission spectrum of the microLEDs. For instance, if the microLED array emits in the blue to green spectrum (450 nm to 550 nm), the sensor is selected to have peak sensitivity in this range. Matching the sensor's spectral response to the illumination wavelength maximizes photon detection efficiency, further improving image quality and reducing exposure times.

### Sensor Size and Field of View

The physical dimensions of the camera sensor device and its active area influence the field of view (FoV) of the imaging system. In a preferred embodiment, the sensor has a diagonal size that matches the dimensions of the sample area in the culture chamber, typically ranging from 5 mm to 15 mm. A larger sensor size increases the FoV, allowing more of the sample to be imaged in a single capture, which is advantageous for applications requiring imaging over a wide area, such as observing large cell cultures or tissue samples. Alternatively, using a smaller sensor size with the same number of pixels effectively increases the system's magnification, enabling the imaging of smaller features within the sample. This configuration is beneficial when high spatial resolution is required over a smaller area, allowing for detailed examination of specific regions of interest.

### Sensor Noise Characteristics

Reducing sensor noise is essential for improving image quality. Preferred configurations include sensors with low readout noise and dark current. Lower readout noise minimizes the electronic noise introduced during signal amplification and conversion, enhancing the detection of weak signals in the diffraction patterns. Reduced dark current decreases the thermal noise generated within the sensor during exposure, which is particularly important for long exposure times or high-sensitivity imaging.

### Global vs. Rolling Shutter

The camera sensor device can employ either a global shutter or a rolling shutter mechanism. In a preferred embodiment, a global shutter sensor is used. A global shutter captures the entire frame simultaneously, eliminating motion artifacts caused by the sequential exposure of pixels in a rolling shutter. This is important when synchronizing the illumination from the microLED array with the sensor exposure, ensuring that the captured diffraction patterns accurately represent the illumination conditions. However, in some embodiments, a rolling shutter sensor may be acceptable if the switching times of the microLEDs are appropriately managed. Rolling shutter sensors often have higher frame rates and lower power consumption. If the timing of the microLED illumination is synchronized with the sensor's readout process, motion artifacts can be minimized, allowing for effective imaging in certain applications.

### Integration of Coded Surface

Preferably, the camera sensor device includes a coded surface arranged on top of the camera sensor surface for allowing retrieval of phase information using coded ptychography or for allowing retrieval of bright field images using coded ptychography. In a preferred configuration, a coded surface, such as a glass surface with phase and intensity scatterers, is integrated directly onto the cover glass of the camera sensor device. The coded surface introduces known modulations into the diffraction patterns, enhancing the robustness and convergence of phase retrieval algorithms. Integrating it onto the sensor minimizes additional spacing and maintains the compactness of the device, contributing to its structural stability and suitability for space-constrained applications.

"**Coded surface**" is a technical term specifically used in the context of ptychography. It refers to a deliberate pattern or structure introduced into the imaging process of ptychography to aid in the reconstruction of high-resolution images from collected data. A coded surface leverages known patterns or structures to enhance the imaging and analysis of samples at a microscopic level.

### Sensor Interface and Data Handling

The camera sensor device interfaces with the electronic control device via a high-speed data connection, such as a MIPI CSI-2 interface. High-speed data transfer is essential for handling the large amounts of data generated during imaging, especially when capturing multiple images for phase retrieval. This ensures that the system operates efficiently without bottlenecks, allowing for real-time processing if required, and enhancing the overall performance of the imaging device.

### Cooling Mechanisms

In certain embodiments, the camera sensor device incorporates passive or active cooling mechanisms to manage thermal noise. Cooling the sensor reduces thermal noise (dark current), improving image quality, especially during long exposures or when operating in high-temperature environments. Passive cooling may involve heat sinks or thermal conduction paths, while active cooling could include thermoelectric coolers. Effective thermal management ensures consistent sensor performance and prolongs the device's operational lifespan.

### Custom Sensor Packaging

Custom packaging of the camera sensor device can enhance its integration into the lensless imaging system. In a preferred embodiment, the sensor is packaged in a way that minimizes its footprint and allows for close proximity to the sample. Reducing the distance between the sensor and the sample improves the system's numerical aperture and resolution. Custom packaging can also facilitate the integration of the coded surface and simplify the mechanical assembly of the device, contributing to its compactness and ease of manufacturing.

### Anti-Reflective Coatings

Applying anti-reflective coatings to the sensor's surface minimizes unwanted reflections that can interfere with the captured diffraction patterns. Reducing reflections enhances the contrast and clarity of the diffraction patterns, improving the effectiveness of phase retrieval algorithms and the quality of the reconstructed images. This modification enhances image fidelity and contributes to more accurate quantitative measurements.

### Sensor Array Configurations

In some embodiments, multiple camera sensor devices are arranged in an array to capture images from different angles or positions. Using multiple sensors can increase the effective field of view or enable three-dimensional imaging through techniques such as computed tomography. It allows for the simultaneous capture of images under different illumination conditions, reducing acquisition time and improving temporal resolution. This configuration expands the imaging device's capabilities and allows for advanced imaging modalities.

### Electronic Control Device and Preferred Configurations

The lensless imaging device includes an electronic control device responsible for controlling both the microLED array device and the camera sensor device. This control device is programmed to perform an image capture process to obtain hologram images of microbial specimens contained within the culture chamber.

In one preferred embodiment, the electronic control device is based on, or respectively includes, an embedded microcontroller, such as a high-performance 32-bit ARM Cortex-M series microcontroller. A microcontroller preferably includes any of: integrated peripherals for communication, timing, and control, such as General-Purpose Input/Output (GPIO) pins, Inter-Integrated Circuit (I²C), Serial Peripheral Interface (SPI), and/or Universal Asynchronous Receiver/Transmitter (UART). A microcontroller preferably operates in real-time, ensuring precise timing and synchronization between the illumination patterns of the microLED array and the image capture by the camera sensor device, which is critical for effective phase retrieval. Its low power consumption makes it advantageous for portable devices or applications where power availability is limited. Additionally, the microcontroller's small footprint contributes to the overall compactness of the imaging device.

In another embodiment, the electronic control device utilizes a single-board computer (SBC), such as the Raspberry Pi Zero 2 W. This SBC incorporates a quad-core ARM Cortex-A53 processor and provides extensive connectivity options, including USB, Wi-Fi, and Bluetooth. The multicore processor enables complex image processing and phase retrieval algorithms to be executed onboard, reducing the need for external processing resources. The flexible software environment allows for the use of high-level programming languages and libraries, facilitating rapid development and deployment of imaging software. Built-in connectivity enables easy integration with other devices, data transfer, and remote control capabilities. This configuration offers a balance between performance and cost, making it suitable for scalable or budget-sensitive applications.

A SBC is preferably programmed to control the operation of the microLED array device and the camera sensor device, preferably handling tasks such as sequencing the illumination patterns, adjusting camera exposure settings, and synchronizing the timing between components. The SBC is preferably programmed to manage data storage, writing both raw and preferably also processed images to the SD card, and preferably facilitate data transfer to other devices via its built-in connectivity options (e.g., Wi-Fi, Bluetooth, USB). Moreover, the SBC may perform the computationally intensive task of converting raw diffraction patterns into meaningful phase contrast images using specialized algorithms implemented in software. However, due to limited processing capabilities of an SBC, the raw images might be transmitted to an external computer device or server/workstation for post-processing of raw images (diffraction patterns, hologram images) into phase contrast images.

An alternative preferred configuration involves the use of a Field-Programmable Gate Array (FPGA) as the electronic control device. FPGAs are integrated circuits that can be programmed to perform specific hardware functions. They offer high-speed parallel processing capabilities, allowing for real-time processing of image data and rapid control of the microLED array. FPGAs provide precise control over timing, ensuring synchronization between the microLED illumination and camera sensor exposure, which is essential for accurate image capture. The hardware can be tailored to specific application needs, optimizing performance for phase retrieval algorithms and image reconstruction tasks. This customization enhances the scalability of the system, accommodating future enhancements or increased complexity.

A further embodiment combines a microcontroller with an FPGA, leveraging the strengths of both components. In this configuration, the microcontroller handles high-level system management and communication tasks, while the FPGA manages time-critical operations such as microLED control and image data processing. This division of tasks allows for efficient use of resources, with the FPGA accelerating computationally intensive functions and the microcontroller maintaining system flexibility. The precise timing provided by the FPGA ensures synchronization between illumination and image capture, improving the quality of the hologram images and enhancing the effectiveness of phase retrieval algorithms.

Another preferred configuration includes the use of a Digital Signal Processor (DSP) within the electronic control device. DSPs are optimized for handling mathematical operations common in image processing and phase retrieval algorithms, enabling faster computation and real-time processing. The specialized architecture of DSPs reduces latency in processing, which is crucial for applications requiring immediate results or feedback. Additionally, DSPs offer high computational performance with lower power consumption compared to general-purpose processors, which is beneficial for battery-operated or energy-sensitive applications.

Implementing a Real-Time Operating System (RTOS) within the electronic control device enhances task management and timing accuracy. An RTOS ensures that high-priority tasks, such as microLED control and image capture, are executed within precise time constraints, improving system reliability. The RTOS allows for concurrent execution of multiple tasks, such as data acquisition, processing, and communication, without interference. This capability enables the system to be expanded with additional functionalities while maintaining real-time performance, supporting future enhancements and increasing the device's adaptability.

Preferred configurations may include advanced interfaces for controlling the microLED array and the camera sensor device. High-speed serial interfaces such as SPI or Low-Voltage Differential Signaling (LVDS) enable rapid data transfer and control signals. Inter-Integrated Circuit (I²C) communication is used for configuring sensor parameters and reading status registers. GPIO expanders can increase the number of controllable outputs for larger microLED arrays. These advanced interfaces improve data throughput, allow for precise manipulation of sensor settings and microLED states, and reduce the complexity of wiring and connections, contributing to the device's compactness and structural stability.

Incorporating power management features into the electronic control device enhances energy efficiency and operational stability. Dynamic power scaling adjusts power consumption based on workload, reducing energy usage and heat generation. For portable applications, integrating battery charging and monitoring capabilities ensures reliable operation. Implementing low-power sleep modes during idle periods conserves energy, extending operational time in battery-powered devices. These features contribute to the longevity of the device and make it suitable for applications where power resources are limited.

Including onboard data storage capabilities and sufficient memory resources is essential for handling large image datasets generated during the imaging process. Storing image data locally enables the device to operate independently of external data links, which is beneficial in remote or inaccessible locations. Adequate memory allows for the implementation of complex algorithms and the handling of high-resolution images without performance degradation. Onboard storage reduces the risk of data loss during transmission and allows for encryption or other security measures to protect sensitive information, enhancing data integrity and confidentiality.

The electronic control device is preferably programmed with specialized software algorithms optimized for image capture, processing, and/or phase retrieval. Software controls the timing and sequencing of microLED illumination and camera exposure, ensuring high-quality hologram images. Implementing efficient algorithms enables real-time reconstruction of images, providing immediate results and facilitating dynamic imaging applications. Software-based control allows for easy updates and modifications to accommodate different imaging modes or to improve performance over time. This flexibility enhances the device's adaptability to various applications and evolving technological advancements.

Integrating network connectivity options, such as Ethernet, Wi-Fi, or Bluetooth, expands the device's capabilities. Remote monitoring and control allow users to access the device remotely to initiate image capture, adjust settings, or retrieve data, increasing flexibility and convenience. Network connectivity facilitates the transfer of large image datasets to external storage or processing facilities, useful in applications requiring extensive data analysis. The device can be incorporated into larger networks or control systems, enabling coordinated operation with other equipment and integration into complex workflows.

Designing the electronic control device with modularity in mind allows for future expansions and customization. Components such as processors, memory modules, or interface boards can be upgraded or replaced without redesigning the entire system. The device can be tailored to specific applications by adding or modifying modules, enhancing versatility. Modular design simplifies troubleshooting and repair, improving reliability and reducing downtime. This approach supports scalability and ensures that the imaging device can adapt to changing requirements or incorporate new technologies.

### Electronic concept

In a preferred embodiment, the electronic control device comprises an Embedded Controller unit (ECU), in particular with a external non-volatile memory item and a Camera Multiplexer. Said devices are connected to the camera sensor device, in particular a Camera module, and the MicroLED array device, in particular a microLED board. The ECU preferably interfaces with the Camera multiplexer through its GPIO pins and the CSI port, communicating also preferably using the I2C protocol. The ECU is preferably responsible to process external commands, trigger the whole image capturing process and store the data on a data storage device, in particular a SD card.

**Ptychography** is an imaging technique used in microscopy to generate high-resolution images of samples, particularly in the field of nanotechnology and materials science, and is usable in biology. It involves reconstructing an object's structure by analyzing the interference patterns created when a beam of light interacts with the sample.

Rather than taking a single image of the entire sample, ptychography involves scanning the sample and capturing a series of diffraction patterns at different positions, the diffraction pattern being referred to as "hologram image" in the context of the present invention. These patterns overlap slightly, and through computational algorithms, the collected data is processed to reconstruct a high-resolution image with details finer than what is possible with conventional microscopy techniques. This method is advantageous for studying materials at the micro- and nanoscale, allowing for the visualization of structures and features that might not be easily observable with other imaging techniques. Ptychography has applications in various scientific fields, including biology, materials science, and nanotechnology.

In ptychography, a coded surface refers to a pattern or structure intentionally introduced into the imaging process. The surface is physically placed within the optical path. It is designed to interact with the sample being studied to help extract more information from the collected data. The coded surface serves as a reference or known pattern that aids in the reconstruction of the sample's features from the diffraction patterns obtained during the scanning process. By using this known pattern and analyzing the resulting interference patterns between the coded surface and the sample, ptychography algorithms can computationally reconstruct a high-resolution image of the sample with improved fidelity and detail.

### Operation of the electronic control device for obtaining raw images, in particular implementing Ptychography

Preferably, electronic control device is programmed to sequentially obtain a set of N different hologram images, wherein the hologram images were obtained by illuminating a culture surface of the culture chamber using different microLEDs of the microLED array, wherein, in particular, the culture surface contains an overlapping area, which is imaged by each of the hologram images of the set.

Phase retrieval is a computational process aimed at reconstructing the complex-valued wavefront W of a sample from intensity-only measurements I, typically captured as hologram images or diffraction patterns. Since the intensity I is the modulus squared of the complex wavefront W (i.e., I=|W|²), retrieving the phase information is inherently challenging because the phase is lost in the intensity measurement. With only a single intensity measurement III, the phase retrieval problem does not have a unique solution due to the loss of phase information. To overcome this ambiguity, multiple hologram images of the sample are captured under slightly different conditions, such as shifted illumination positions or varied illumination angles. These shifts introduce diversity in the captured data, providing additional constraints that aid in uniquely determining the phase.

For two-dimensional samples, a minimum of four slightly shifted hologram images is theoretically required to obtain a unique solution for the phase retrieval problem. This number arises from the need to provide sufficient independent measurements to resolve the ambiguities in phase reconstruction. For three-dimensional samples, the complexity increases, and at least eight hologram images are preferred for a unique solution. This accounts for the additional dimensionality and the increased degrees of freedom in the sample's structure.

To achieve a theoretically perfect reconstruction of the phase for 2D samples, eight hologram images are required. The additional images provide redundancy and help in compensating for noise and imperfections in the measurements. For 3D samples, twelve hologram images are preferred for a perfect solution. The extra images contribute to resolving the complexities inherent in three-dimensional structures.

In practical applications, it is often possible to obtain good reconstructions with fewer images than the theoretically required minimum. Advanced algorithms and computational techniques can compensate for the limited data to some extent.

Since the microscope system of the present invention is intended to image both 2D and 3D samples, capturing at least 12 hologram images is considered necessary to have a chance for theoretically perfect phase retrieval in 3D. This ensures that the device can handle complex samples and produce accurate reconstructions.

Capturing more images generally leads to better image reconstruction quality. The additional data provides more information about the sample, reduces noise, and improves the robustness of the phase retrieval algorithms. However, more images increase the data volume, affecting the data budget, storage requirements, and transmission bandwidth. Additionally, capturing more images can lead to increased thermal load due to longer operation times, which may affect the device's performance and longevity.

Reducing the number of images conserves data storage and reduces thermal stress on the device. It also speeds up the data acquisition process. However, with fewer images, the reconstruction quality may degrade due to insufficient data to fully resolve the phase ambiguities and compensate for noise.

Preferably, the lensless imaging device is configured to capture a maximum number of hologram images to image a sample, preferably up to 256 or 128 hologram images, providing flexibility to achieve high-quality reconstructions when needed. However, through optimization of the illumination placement and algorithmic efficiency, good reconstruction quality can be achieved with fewer hologram images-potentially less than 30, preferably 6 to 12 hologram images. This balance allows for adaptability based on the specific imaging requirements and constraints of each use case.

Preferably, the total number N of hologram images of the set of hologram images is between 2 <= N <= 256, preferably between 4 <= N <= 100, most preferably between 4 <= N <= 30. By selecting N within these ranges, the device can achieve a good compromise between image reconstruction quality and practical considerations such as data storage capacity and thermal management.

By sequentially capturing hologram images with different microLEDs illuminating the same overlapping area, the system collects a diverse set of diffraction patterns containing complementary spatial frequency information about the sample. Each microLED, positioned differently within the array, provides a unique illumination angle or position relative to the sample. This diversity is a basis for phase retrieval algorithms, such as coded ptychography or iterative phase retrieval, which rely on multiple measurements to reconstruct both the amplitude and phase of the sample's optical field. The overlapping area ensures that the phase retrieval algorithms have consistent reference points across all hologram images, improving convergence and robustness. This results in high-resolution reconstructed images with enhanced detail and accuracy.

Using different microLEDs to illuminate the same area effectively increases the system's synthetic numerical aperture (NA). Each microLED contributes a different positional or angular component to the illumination, and when combined, these positions or angles cover a wider range than a single illumination source could provide. The increased NA leads to improved resolution beyond the diffraction limit imposed by a single illumination angle. The overlapping area benefits directly from this enhanced resolution, allowing the imaging device to resolve finer details within the sample.

Sequential imaging with multiple microLEDs helps mitigate artifacts and noise inherent in single-shot holography. Variations in illumination conditions, such as intensity fluctuations or coherence artifacts, can be averaged out or corrected during the reconstruction process. The overlapping area imaged in all holograms allows for consistent comparison and combination of data, reducing random noise and systematic errors. This leads to clearer images with higher signal-to-noise ratios.

Preferably, the electronic control device is programmed to perform an image capture process for obtaining a background image, in particular an image of the culture chamber without any microbial specimen contained in the culture chamber and/or to store a background image in form of background image data in the data storage device, the background image data being assigned to the hologram image data.

Preferably, the electronic control device is programmed to perform an image capture process for obtaining a darkfield image of the microbial specimen contained in the culture chamber, and/or to store a darkfield image in form of darkfield image data in the data storage device, the darkfield image data being assigned to the hologram image data.

Quantitative phase imaging requires precise measurement of the optical path length variations caused by the sample. The multiple hologram images obtained under different illumination conditions provide the necessary data redundancy and diversity for accurate phase retrieval. The consistent overlapping area ensures that the phase information is accurately reconstructed for the same region across all holograms. This consistency enhances the reliability of quantitative measurements, enabling precise analysis of the sample's physical properties.

Programming the electronic control device to use different microLEDs allows for customizable illumination strategies. Users can select specific microLEDs or sequences to optimize imaging based on the sample's characteristics or experimental requirements. This flexibility enables the device to adapt to various imaging scenarios, such as emphasizing certain features, enhancing contrast, or compensating for sample-induced aberrations. The overlapping area serves as a controlled region for assessing the effects of different illumination strategies.

By electronically controlling the microLEDs to change illumination positions, the system avoids the need for mechanical movement of components or the sample. Eliminating mechanical scanning reduces the complexity, size, and potential mechanical failures of the device. It increases imaging speed and allows for rapid acquisition of holograms, which is beneficial for dynamic or real-time imaging applications.

The varying illumination positions or angles provided by different microLEDs can be exploited to perform three-dimensional reconstructions of the sample through techniques like optical diffraction tomography. The overlapping area ensures that depth information is consistent across all holograms, facilitating accurate 3D reconstruction. This expands the imaging device's capabilities to include volumetric imaging, valuable in fields like biology and materials science.

Consistently imaging the same overlapping area with different microLEDs allows for system calibration and correction of aberrations. Discrepancies between hologram images can be analyzed to identify and correct for system-induced errors, such as misalignments or optical aberrations. This leads to improved overall imaging accuracy and repeatability.

While the overlapping area is common to all hologram images, each hologram image may also contain unique regions of the sample. Combining information from all hologram images can effectively increase the field of view. High-resolution imaging is maintained in the overlapping area, while additional areas are imaged with varying degrees of resolution, allowing for comprehensive sample analysis.

The availability of multiple hologram images of the same area under different illumination conditions enriches the dataset used by computational imaging algorithms. Advanced algorithms can leverage this rich dataset to perform tasks such as super-resolution imaging, denoising, and artifact removal. The overlapping area benefits from the full potential of these algorithms, resulting in superior image quality.

Preferably, the electronic control device is programmed to sequentially obtain a set of hologram images, which are obtained by controlling an individual microLED of the microLED array, the set including, in particular, a first hologram image obtained by illuminating the receiving space using a first microLED and a second hologram image obtained by illuminating the receiving space using a second microLED, which is different from the first microLED. Herein, sequentially obtaining the images means that the microLEDs are activated one after the other, whereby only one microLED is active at a time while the other microLEDs are deactivated, or wherein only a fraction of microLEDs is active at a time while the other microLEDs are deactivated, the fraction containing 2 or more microLEDs, in particular a maximum of 10 LEDs.

Preferably, the electronic control device is programmed to obtain a first hologram image obtained by illuminating the receiving space using a first microLED and a second hologram image obtained by illuminating the receiving space using a second microLED, the first microLED being separated from the second microLED by an LED pitch "PL".

### Super-Resolution

It is preferred that PL > PS, wherein preferably PL = c * PS with preferably c= between 2 and 10, PL being the LED pitch PL of the microLED array, and PS being the sensor pixel pitch of the sensor matrix, wherein, in particular, the electronic control device is programmed to obtain a first hologram image obtained by illuminating the receiving space using a first microLED and a second hologram image obtained by illuminating the receiving space using a second microLED, the first microLED being separated from the second microLED such that PF is a non-integer multiple of PS, in particular c being non-integer, e.g. c= 2.5.

By choosing c as a non-integer (e.g., c=2.5), illuminating the sample with different microLEDs results in hologram images that are shifted by a fraction of the sensor's pixel pitch PS. This creates sub-pixel displacements in the captured diffraction patterns without physically moving the sensor or sample. The sub-pixel shifts introduce additional spatial sampling points between the sensor's fixed pixels, effectively increasing the sampling resolution of the system. The additional information from the sub-pixel shifted images allows computational algorithms to reconstruct images with spatial resolution finer than the sensor's native pixel pitch PS. The fractional shifts provide more diverse data for phase retrieval algorithms, enhancing the reconstruction of both amplitude and phase information of the sample.

Super-resolution imaging aims to overcome the resolution limit imposed by the sensor's pixel size by utilizing additional information from multiple images. In this context, the multiple hologram images captured under different illumination positions provide slightly shifted versions of the diffraction patterns due to the non-integer relationship between PL and PS. The electronic control device sequentially activates microLEDs separated by PF, causing the illumination to shift by a fractional amount relative to the sensor pixels. For example, with c=2.5, PL=2.5×PS. The shift between the first and second microLEDs corresponds to 0.4×PS (since 1/c=0.4), resulting in a sub-pixel shift. The captured hologram images are aligned and combined using super-resolution algorithms that exploit the sub-pixel shifts to reconstruct a higher-resolution image. Techniques like iterative backprojection, maximum likelihood estimation, or Fourier-based methods are employed to integrate the information from multiple images. The combined data provides more information about the sample's high-frequency components, leading to images with finer detail than what the sensor's pixel size would normally allow. Sub-pixel shifts help in mitigating aliasing artifacts by effectively increasing the system's sampling rate.

Super-resolution is achieved electronically by controlling the microLEDs, eliminating the need for mechanical scanning systems, which reduces complexity and potential mechanical errors. Sequential electronic control allows for rapid acquisition of multiple images necessary for super-resolution, enabling faster imaging compared to methods requiring physical movement. The technique leads to higher-resolution images with improved contrast and reduced noise, benefiting applications requiring detailed visualization of microscopic structures.

### Special distances of the main parts

Preferably, the imaging device comprises the culture chamber being inserted in the receiving space in an inserted position of the culture chamber,
the culturing chamber comprising a culture surface for supporting the microbial specimen, and the culture surface being positioned in a second distance d2 to the camera sensor surface and the culture surface being positioned in a third distance d3 to the microLED array device, wherein the third distance is larger than the second distance in the inserted position of the culture chamber, or wherein the second distance is equal to or larger than the third distance in the inserted position of the culture chamber, wherein, in particular, the camera sensor surface may be a coded surface.

Preferably, d2 = f1 * d3 or d3 = f2 * d2, f1 taken from the range 0.05 to 0.5, preferable f1 taken from the range 0.1 to 0.2, f2 taken from the range 0.05 to 1. Preferably, d3 is taken from the range 5.0 mm to 50.0 mm, preferably 5.0 mm <= d3 <= 20.0 mm, preferably 7.0 mm <= d3 <= 9.0 mm. A culture surface closer to camera surface is easier on reconstruction and has a larger FoV, but less resolution, and a culture surface further away from a camera surface has a smaller FoV but higher resolution due to the magnification effect of the point light source.

By carefully choosing the distances d2 and d3, the lensless imaging device can be tailored to balance resolution and field of view according to specific application needs. Positioning the culture surface closer to the camera sensor surface results in easier reconstruction and a larger FoV, suitable for applications where imaging speed and area coverage are prioritized over fine detail. Conversely, placing the culture surface further from the camera sensor enhances resolution due to the magnification effect of the microLEDs, suited for applications requiring detailed imaging of microscopic features, albeit with a smaller FoV and increased computational demands for image reconstruction. The inclusion of a coded surface on the camera sensor further enhances these effects by improving phase retrieval performance.

### Culture Chamber and Preferred Embodiments

The culture chamber is a preferably removable or fixed component of the lensless imaging device, designed to facilitate the cultivation and imaging of microbial specimens and living cells. Positioned within the receiving space between the camera sensor device and the microLED array device, the culture chamber provides a, preferably controlled, environment for the specimens while allowing high-resolution imaging without the need for traditional optical elements. The design and configuration of the culture chamber influence the imaging performance, sample viability, and overall functionality of the device.

The culture chamber preferably comprises or is constructed from optically transparent materials, such as glass or biocompatible polymers like polystyrene or polymethyl methacrylate (PMMA). This transparency allows unimpeded transmission of light between the microLED array device and the camera sensor device, ensuring that the emitted illumination reaches the sample and that the resulting diffraction patterns are accurately captured.

The chamber preferably includes a culture surface designed to support the microbial specimens or living cells. This surface may be treated or coated to enhance cell adhesion and growth, utilizing materials like extracellular matrix proteins or specialized coatings. The culture surface is preferably positioned at a specific distance from the camera sensor surface and the microLED array device to balance resolution and field of view, as previously described.

The culture chamber preferably provides a sealed environment to maintain sterility and control environmental conditions such as humidity, temperature, and gas composition. It may include features like gasket seals, O-rings, or integrated lids to prevent contamination and evaporation of the culture medium.

To maintain the compactness of the imaging device and minimize optical path length variations, the culture chamber is designed with a thin profile. The chamber's thickness is minimized while ensuring sufficient space for the specimens and culture medium, typically ranging from 0.1 mm to 2 mm.

The materials and construction of the culture chamber are preferably compatible with standard sterilization techniques, such as autoclaving, gamma irradiation, or chemical sterilization. This ensures that the chamber can be prepared for use without introducing contaminants that could affect the specimens or imaging quality.

The culture chamber is designed to be easily inserted and removed from the receiving space, allowing for straightforward replacement or exchange between experiments. This feature enhances the usability of the device and enables high-throughput applications.

In a preferred embodiment, the culture chamber is configured as a closable and sealable container. Preferably, the culture chamber is capable to be positioned or is positioned in the holder device for allowing an exchange of liquid inside the culture chamber without removing the culture chamber from the mounting position inside the receiving space.

Preferably, the culture chamber is capable to contain a liquid, or contains a liquid, without leakage, when the culture chamber is oriented in three perpendicular directions in space or on earth, and/or with respect to the direction of gravity. The liquid may be a cell culture medium or other nutrient.

In a preferred embodiment, the culture chamber is configured as a microfluidic device with integrated channels and reservoirs for fluid handling. This configuration allows precise control over the delivery of culture media, nutrients, and reagents to the specimens. The microfluidic design enables dynamic environment control, reduced sample volume, and enhanced imaging stability by minimizing fluid movement and vibrations.

Another embodiment features a culture chamber divided into multiple wells or compartments, each capable of housing separate specimens or experimental conditions. This allows for parallel experiments, isolation of specimens, and compatibility with standard laboratory equipment and workflows.

In this embodiment, the culture chamber is made from flexible materials that can conform to the shape of the camera sensor device or the microLED array device. This ensures improved contact, versatility, and reduced air gaps, which minimizes refractive index mismatches and optical aberrations.

The culture chamber may include integrated optical elements, such as diffraction gratings or microlenses, embedded within or on its surfaces. These elements enhance imaging contrast, assist in phase retrieval algorithms by introducing known optical modulations, and simplify system design by reducing the need for additional external optical components.

An embodiment includes integrated temperature control, such as any of: heating elements and/or thermal conduction paths, temperature sensor, CO2 and/or O2 and/or gas control, in particular humidity control. This maintains optimal growth conditions for the specimens, ensures stability by preventing thermal fluctuations, and eliminates the need for external incubators or temperature control systems. In a further embodiment, the culture chamber forms an incubator for a microbial sample.

The chamber may be constructed from gas-permeable materials or include membranes that allow for gas exchange while maintaining a sealed environment. This provides necessary oxygen and carbon dioxide exchange for aerobic or anaerobic organisms, maintains sterility, and enhances imaging conditions by avoiding condensation or pressure buildup.

In another embodiment, the culture chamber is designed as a disposable insert that can be easily replaced after each experiment. This reduces the risk of cross-contamination, simplifies preparation and cleanup processes, and is cost-effective for high-throughput applications.

The culture surface itself may include optical coding, such as micro-patterns or textures, that assist in phase retrieval or provide reference points for image alignment. This improves reconstruction accuracy, provides a built-in reference for calibrating the imaging system, and enhances feature detection.

An embodiment allows for the adjustment of the chamber's thickness or the distance between the culture surface and the imaging components. This enables optimized imaging parameters by adjusting distances, accommodates different specimen types, and provides ease of use with adjustment mechanisms designed for straightforward operation without compromising sterility.

The culture chamber may include integrated sensors for monitoring environmental conditions, such as pH, dissolved oxygen, or cell density. This provides real-time feedback, allows data correlation between environmental data and imaging results, and supports automation for maintaining optimal culture conditions.

Preferably, the culture chamber has a top wall and a bottom wall arranged in parallel and arranged in parallel to the camera sensor surface, the bottom wall having an inner side facing the inside of the culture chamber, the inner side comprising the culture surface.

Preferably, the culture chamber has microfluidic connectors for exchanging a liquid culture medium via external channels connected to the microfluidic connectors.

### Microscope system and Postprocessing

A microscope system including the lensless imaging device is configured to utilize a unique combination of computational techniques to transform a set of hologram images (diffraction patterns) into a brightfield image and/or phase contrast image of a microbial specimen or living cells - this is called post-processing. The post-processing steps are specifically tailored to leverage the device's key features, particularly the microLED array and the capability to capture multiple holograms with varying illumination conditions. The microscope system, in particular the electronic control device or the computing device, is preferably programmed to store the reconstructed brightfield- and/or phase contrast image in a data storage device of the lensless imaging device or of the microscope system.

Firstly, the lensless imaging device captures multiple hologram images by sequentially illuminating the sample with different microLEDs within the array. Each microLED provides a unique illumination angle or position due to its specific location, and all hologram images capture an overlapping area of the sample to ensure consistency and data redundancy. By setting the LED pitch PL to be a non-integer multiple of the sensor pixel pitch PS (for example, PL=2.5×PS), the device introduces sub-pixel shifts in the illumination patterns, which is beneficial for achieving super-resolution imaging, if desired.

The captured hologram images undergo preprocessing steps that include, optionally, background correction to remove noise or sensor artifacts and/or optionally intensity normalization to adjust for variations in illumination brightness or exposure settings. An optional step of alignment verification may ensure that the overlapping areas in all hologram images are properly aligned, correcting for any minor shifts or distortions.

The core of the post-processing involves applying a phase retrieval algorithm using, in particular, coded ptychography. The known positions and patterns of the microLEDs provide coded illumination, enhancing the diversity of the captured diffraction data. The electronic control device or a computer device employs algorithms such as the Extended Ptychographical Iterative Engine (ePIE) or Momentum-accelerated Ptychographic Iterative Engine (PIE), which utilize the overlapping regions in the holograms to reconstruct the complex optical field of the sample. If the lensless imaging device includes a coded surface on the camera sensor device, such as a phase mask, this known modulation is integrated into the phase retrieval algorithm to improve convergence and accuracy.

Exploitation of sub-pixel shifts is a basis of the lensless imaging device's optional super-resolution capability. The non-integer relationship between PL and PS creates fractional pixel shifts in the holograms, used to sample the diffraction pattern at a higher resolution than the sensor's native pixel size. By combining information from the multiple sub-pixel shifted holograms, the system reconstructs an image with spatial resolution exceeding that of the individual sensor pixels.

The iterative reconstruction process involves simulating the propagation of the optical field between the sample plane and the sensor plane using numerical methods like the Fresnel or angular spectrum approach. Constraints are preferably applied during this process: at the sensor plane, the simulated amplitude may be replaced with the square root of the measured intensity from the holograms while retaining the phase information; at the sample plane, known properties of the sample, such as finite support and non-negativity, may be used to refine the reconstruction. These steps may be repeated iteratively until convergence is achieved, resulting in an accurate reconstruction of the sample's amplitude and phase.

Once the complex optical field is reconstructed, the amplitude provides the brightfield image, representing the absorption or scattering characteristics of the sample, while the phase yields the phase contrast image, revealing variations in optical path length due to refractive index changes or thickness variations in the sample. Post-reconstruction processing preferably includes noise reduction through filtering techniques, preferably contrast enhancement to highlight important features, and preferably phase unwrapping algorithms if necessary to convert the wrapped phase map into a continuous phase profile for accurate quantitative analysis.

For visualization and analysis, the quantitative phase information may be used to measure physical properties such as cell thickness, refractive index variations, or morphological changes. Visualization tools like color maps or three-dimensional surface plots may effectively represent the phase data, aiding in interpretation and analysis.

To optimize for real-time processing, the electronic control device or a computer device preferably leverages the computational capabilities of a Raspberry Pi or any computer, in particular dedicated GPUs, to accelerate the reconstruction algorithms. Efficient code implementation and algorithm optimization reduce computational load and processing time, enabling near real-time imaging when necessary.

A basis for the imaging approach in this lensless imaging device is a control over individual microLEDs for customizable illumination patterns and preferably sub-pixel shifting for achieving super-resolution, the use of overlapping areas in holograms to enhance data redundancy and reconstruction robustness, the integration of coded illumination and surfaces to aid in resolving phase ambiguities and accelerate algorithm convergence, and potentially achieving super-resolution without moving parts to increase system reliability and reduce complexity.

### Ptychographical Iterative Engine

The electronic control device or a computer device, also referred to as computing device, of the microscope system, preferably, is programmed to apply a Ptychographical Iterative Engine (PIE) algorithm to reconstruct both the amplitude and phase of a sample imaging by analyzing overlapping diffraction patterns obtained from different illumination positions, for obtaining a brightfield image and/or a phase contrast image from the hologram images. The PIE may be a Ptychographical Iterative Engine (ePIE) or a Multimodal Ptychographical Iterative Engine (mPIE).

The Extended Ptychographical Iterative Engine (ePIE) and the Multimodal Ptychographical Iterative Engine (mPIE) are advanced computational algorithms used in ptychography-a lensless imaging technique that reconstructs both the amplitude and phase of a sample by analyzing overlapping diffraction patterns obtained from different illumination positions. These algorithms are particularly relevant to the lensless imaging device described, which utilizes a microLED array to sequentially illuminate a sample and capture multiple hologram images.

### Extended Ptychographical Iterative Engine (ePIE)

The ePIE algorithm extends the original Ptychographical Iterative Engine (PIE) by simultaneously updating both the sample (object) function and the probe (illumination) function during the iterative reconstruction process. This simultaneous update is applied when the probe is not perfectly known or has imperfections, which can occur with individual microLEDs in the array.

The basic aspects of ePIE involve the following steps:
1. Simultaneous reconstruction of object and probe: The algorithm begins with initial estimates for both the object function (representing the sample) and the probe function (representing the illumination). In each iteration, both functions are updated to improve the accuracy of the reconstruction.
2. Overlapping Illumination: The sample is illuminated at multiple positions with overlapping regions. The microLED array facilitates this by sequentially activating different microLEDs that illuminate overlapping areas of the sample. This overlap ensures redundancy in the data, which is essential for accurate phase retrieval and helps resolve ambiguities in the reconstruction.
3. Iterative algorithm steps may include any of the following:
   ∘ Compute exit wave: At each scan position, the exit wave is calculated by multiplying the current estimates of the object and probe functions.
   ∘ Propagate to detector plane: The exit wave is propagated to the detector plane (camera sensor) using a propagation model such as Fresnel or Fraunhofer diffraction, simulating the diffraction pattern that would be measured.
   ∘ Apply intensity constraint: The amplitude of the simulated diffraction pattern is replaced with the square root of the measured intensity from the actual hologram image, while retaining the phase information. This step enforces consistency with the observed data.
   ∘ Backpropagate to sample plane: The modified wave is backpropagated to the sample plane.
   ∘ Update object and probe functions: The object and probe functions are updated based on the differences between the estimated and measured data. The updates are weighted to ensure convergence.
   ∘ Iteration: These steps are repeated for all scan positions and continued over multiple iterations until the reconstruction converges.

By updating the probe function, ePIE compensates for imperfections or uncertainties in the illumination from the microLEDs. Simultaneous updates of both functions lead to faster and more reliable convergence compared to algorithms that keep the probe fixed. The algorithm is suitable for various experimental conditions, including variable probe illumination, making it well-suited for the microLED array setup.

### Momentum Accelerated Ptychographical Iterative Engine (mPIE)

The mPIE algorithm extends the capabilities of ePIE to handle especially difficult phase retrieval cases such as when the illumination has complex structures arising from partial coherence, multiple wavelengths, or spatial variations.

The basic aspects of mPIE involve:
1. In addition to the approaches of rPIE a "momentum" is added to the algorithm which prevents the algorithm from becoming stuck in local optima.
2. Iterative algorithm steps are described below in detail.

mPIE provides quick convergence especially for extremely difficult datasets where other implementations of the PIE algorithm fail to converge. The algorithm is adaptable to a wide range of imaging scenarios, including multispectral and multimodal imaging.

RD8 provides an overview and comparison of different implementation for PIE, in particular mPIE (RD8: A. Maiden, D. Johnson, and P. Li, "Further improvements to the ptychographical iterative engine," Optica, vol. 4, no. 7, p. 736, Jul. 2017, doi: 10.1364/OPTICA.4.000736.).

### Application in the Lensless Imaging Device

In the context of the lensless imaging device, these algorithms are preferably applied in the post-processing of hologram images to obtain brightfield and phase contrast images, in particular in high-resolution quality:
- ePIE is particularly advantageous because the individual microLEDs may have variations in their emission profiles or may not be perfectly uniform. By simultaneously reconstructing the sample and the probe, ePIE compensates for these variations, leading to more accurate phase contrast images.
- mPIE becomes relevant if the microLEDs exhibit multiple spatial modes or if there is partial coherence in the illumination. By accounting for multiple probe modes, mPIE enhances the reconstruction quality under these complex illumination conditions.

The lensless imaging device captures multiple hologram images by sequentially illuminating the sample with different microLEDs, ensuring overlapping illuminated regions. These overlapping regions provide the necessary data redundancy for the algorithms to effectively reconstruct the sample's complex optical field.

During the iterative reconstruction process, the algorithms simulate the propagation of the optical field between the sample plane and the detector plane, apply constraints based on the measured intensities, and update the estimates of the object and probe functions. This process is repeated until convergence is achieved, resulting in accurate reconstructions of both the amplitude and phase information of the sample.

### Incubator with lensless imaging device

The invention is also related to an incubator having an incubator chamber, which contains the lensless imaging device according to the invention, being mounted inside the incubator chamber, for example on a random positioning machine (RPM), described below. In this case, the design of the culture chamber used in the lensless imaging device is simpler, because the culture chamber does not need any means for incubating the samples. The electronic control device of the incubator may be the same as the electronic control device of the lensless imaging device or may be a different device. Any post-processing of hologram images obtained by the lensless imaging device may be performed by the electronic control device, a computing device in the incubator, or a computing device external to the incubator.

An incubator for incubating microbials, particularly living cells, is a generally known device that provides a stable and controlled environment to support growth and experimentation. The chamber, typically constructed from corrosion-resistant materials such as stainless steel or plastic, is closed or sealed to create a contamination-free interior. Temperature control is a basic feature, achieved through heating elements that maintain a constant and precise temperature, usually around 37°C for mammalian cells, with some models also including cooling systems for experiments requiring lower temperatures.

Humidity control is preferably provided, to achieve high humidity levels, often between 85% and 95%. Gas control systems regulate CO₂ concentrations, commonly set at 5% for maintaining pH balance in bicarbonate-buffered media, with advanced models offering oxygen regulation for hypoxic or hyperoxic conditions tailored to specific cell needs. The incubator, in particular the interior or the chamber, is equipped with sensors to monitor and regulate key parameters like temperature, humidity, and gas levels, all managed through a control panel that allows adjustments and/or by remote control.

### Random Positioning Machine with lensless imaging device

The invention is also related to a Random Positioning Machine (RPM) having a movable supporting base, wherein a lensless imaging device according to the invention is mounted to the supporting base. The electronic control device of the RPM may be the same as the electronic control device of the lensless imaging device or may be a different device. Any post-processing of hologram images obtained by the lensless imaging device may be performed by the electronic control device, a computing device in the RPM, or a computing device external to the RPM.

A Random Positioning Machine (RPM) is a laboratory instrument configured to simulate various gravitational conditions, including microgravity and partial gravity, by continuously altering the orientation of a sample along multiple axes. This dynamic reorientation effectively averages out the gravitational vector over time, creating an environment that mimics the weightlessness experienced in space. The RPM is preferably capable of operating in multiple motion modes, such as clinostat, random, and partial-g.

The RPM may comprise two independently rotating frames-an inner frame nested within an outer frame. Each frame can rotate around its own axis, allowing for complex, multidirectional movement patterns. This dual-axis configuration enables the simulation of various gravitational conditions by altering the sample's orientation in three-dimensional space. Gravity Levels may be adjustable between 10-3 g and 0.9 g (e.g. Moon or Mars gravity).

A control system, preferably integrated into or remote from the RPM, may be configured to manage the rotation speeds and patterns of both frames. It provides any of the following modes or preferably allows users to select and program different motion modes, including:
∘ Clinostat Mode: Rotates the sample at a constant speed around a single axis, effectively nullifying the directional influence of gravity.
∘ Random Mode: Continuously changes the sample's orientation in a random pattern, simulating microgravity conditions by averaging the gravitational vector over time.
∘ Partial-g Mode: Adjusts the rotation to simulate partial gravity levels, such as those found on the Moon or Mars, by controlling the duration and orientation of exposure to Earth's gravity.

The RPM, in particular the inner frame, may comprise a support platform or holder, where the experimental sample, or respectively an installation, like the lensless imaging device, is secured. This platform is designed to accommodate various types of installations and samples, including biological cultures, plants, or small animals, and is engineered to minimize mechanical stress during rotation.

The RPM may be equipped with sensors to monitor parameters such as rotation speed, orientation, and environmental conditions within the sample chamber. These sensors provide real-time feedback to the control system, ensuring precise operation and the ability to replicate specific experimental conditions.

The RPM may be equipped with a software interface that allows users to program and control the RPM's operation. Users may be able to set parameters for rotation speed, select motion modes, and monitor system status, facilitating tailored experimental setups.

Depending on the application, the RPM may include enclosures to contain the sample environment, prevent contamination, and ensure user safety during operation.

The invention is also related to aerospace experimental module having a payload space, being, in particular, limited, preferably to a volume between 0.5, 1 to 40 or 50 dm³, in particular to 1 dm³ wherein a lensless imaging device according to the invention is mounted inside the payload space.

An aerospace experimental module is preferably configured to be a modular experiment container to facilitate biological research in microgravity environments, e.g. during spaceflight missions. A modular experiment container is designed to house various types of biological samples, including cells, plants, and small organisms, providing a controlled environment for experiments conducted aboard spacecraft like the International Space Station (ISS).

Each modular experiment container may comprise or consist of an outer shell (experiment container) and interchangeable inner shells (experiment inserts), allowing customization based on specific experimental requirements.

A modular experiment container may be configured to be compatible with ISS facilities, including those operated by Space Tango, BioServe, LaMont, Ice Cubes, and Kayser Italia, ensuring flexibility in deployment across different platforms.

In addition to spaceflight applications, a modular experiment container can be used with ground-based microgravity simulators like the Random Positioning Machine (RPM) and Clinostat, enabling researchers to conduct preliminary experiments before space missions. The aerospace experimental module, in particular including a lensless imaging device of the invention, may also be mounted on the support platform of an RPM, to perform experimental testing before launching the experiment.

The invention is also related to a microscope system comprising a lensless imaging device according to the invention and a computing device, the computing device being configured to receive, preferably via a wireless or wired connection, hologram image data representing at least one hologram image and the computing device being programmed to execute a post processing algorithm or method for reconstructing a microscope image of the of microbial specimen contained in the culture chamber from the hologram image data, the microscope image being a brightfield image or a phase contrast image.

To effectively perform the ptychographic or non-ptychographic methods required for reconstructing microscope images from hologram data, the computing device is preferably equipped with high-performance hardware components that can handle intensive computational tasks and large datasets. This may include any of: a multi-core CPU, a dedicated GPU with substantial memory and parallel processing capabilities, ample RAM, and fast storage solutions like SSDs. The device preferably supports wired or wireless high-speed data transfer interfaces for efficient communication with the lensless imaging device and be compatible with necessary software frameworks and libraries. These specifications may ensure that the computing device can execute complex iterative reconstruction algorithms efficiently, providing accurate and high-resolution brightfield or phase contrast images of microbial specimens. Modern computing devices may use a state-of-the-art ARM processor, which are energy efficient and provide sufficient computing power for implementing a sufficiently powerful microscope system according to the invention.

### Alternative Methods to Ptychography for Phase Reconstruction in the Microscope system

In the lensless imaging device, hologram images (diffraction patterns) are captured to reconstruct detailed images of microscopic samples. While ptychography is a powerful method for phase retrieval and high-resolution imaging, several alternative techniques can be applied to the hologram images obtained by such devices. These alternatives offer various advantages in terms of experimental simplicity, computational efficiency, and suitability for different sample types or imaging conditions.

Digital holography involves recording the interference pattern between a reference beam and the object beam that has interacted with the sample. By numerically reconstructing the hologram using Fourier or Fresnel transforms, both amplitude and phase information of the sample can be retrieved. In the context of a lensless imaging device, if a reference wave can be introduced or simulated, digital holography can be employed to reconstruct the phase information directly from the captured hologram images. This method allows for real-time reconstruction and is suitable for applications requiring fast processing.

The Transport of Intensity Equation (TIE) relates the intensity variations along the optical axis (propagation direction) to the phase distribution of the sample. By capturing a series of slightly defocused intensity images, the phase can be reconstructed by solving the TIE numerically. In a lensless imaging device, adjusting the distance between the sample and the sensor or varying the illumination can provide the necessary intensity variations. The TIE method is non-interferometric and does not require a reference beam, making it compatible with simple experimental setups.

The Gerchberg-Saxton algorithm is an iterative phase retrieval technique that alternates between the spatial domain and the Fourier domain, applying known constraints in each domain to reconstruct the phase. For lensless imaging devices capturing hologram images, this algorithm can be applied by using the measured intensity at the sensor plane and incorporating prior knowledge or assumptions about the sample in the object plane. Though convergence is not always guaranteed and may require careful initialization, it is a straightforward method that can be implemented without additional hardware modifications.

The Hybrid Input-Output (HIO) algorithm is an extension of the Gerchberg-Saxton method, introducing a feedback parameter to improve convergence and avoid stagnation. By updating the phase estimate using a combination of current and previous iterations, the HIO algorithm can handle non-convex problems more effectively. In lensless imaging devices, applying the HIO algorithm to the hologram images can enhance phase reconstruction, especially when dealing with complex samples or noisy data.

This method uses the angular spectrum representation to propagate the optical field between planes and iteratively retrieve the phase information. By initializing with an estimated phase, the field is propagated to the sensor plane using the angular spectrum method, and measured intensity constraints are enforced. The field is then backpropagated to the sample plane, and object constraints are applied. Repeating this process allows for the reconstruction of the sample's phase. The iterative angular spectrum method is well-suited for lensless imaging setups and can handle near-field propagation and large numerical apertures.

In digital Gabor holography, the hologram is recorded without a separate reference beam, as in in-line holography. The recorded hologram contains the interference between the object wave and a background reference wave inherent in the setup. Numerical reconstruction techniques can then be applied to extract the phase information. This method simplifies the optical setup and is compatible with lensless imaging devices that capture hologram images without additional reference beams.

By introducing a known modulation, such as a coded aperture or phase mask, into the optical path, it is possible to enhance the phase retrieval process. The coded aperture modifies the hologram in a way that provides additional constraints for the reconstruction algorithm. In lensless imaging devices, incorporating a coded surface on the sensor or in the illumination path allows the use of phase retrieval algorithms that exploit this known modulation to recover the phase information from the hologram images.

Recent advancements have seen the application of machine learning techniques, particularly deep learning, for phase retrieval. Neural networks can be trained on simulated or experimental data to learn the mapping from hologram images to the corresponding phase information. In lensless imaging devices, a convolutional neural network (CNN) could be employed to process the captured hologram images and output reconstructed phase images. This approach can provide rapid reconstruction and may handle complex samples effectively, though it requires a substantial amount of training data and computational resources for training.

Techniques such as Fourier ptychography or single-shot holography methods can be adapted to reconstruct phase information without multiple exposures or mechanical scanning. By using multiplexed illumination patterns or exploiting the properties of partially coherent light, it is possible to retrieve phase information from a single hologram image. In lensless imaging devices, optimizing the illumination scheme or using specially designed diffractive elements can enable these single-shot methods.

Transport-based phase retrieval methods utilize the natural propagation of light and the transport of intensity to infer phase information. By modeling the light propagation from the sample to the sensor and fitting the measured intensities to the model, the phase can be reconstructed. In lensless imaging devices, where the distance between the sample and the sensor is small and known, these methods can be particularly effective.

### Further post processing steps

The microscope system is preferably configured such that the post processing method comprises any of the following programmed steps:
- optional: using background image data assigned to the hologram image to remove a background based image feature from the hologram image and to obtain hologram image data being background corrected;
- optional: using darkfield image data assigned to the hologram image to remove a darkfield based image feature from the hologram image and to obtain hologram image data being darkfield corrected;
- perform a holographic image reconstruction using the hologram image data, which may or may not be background- and/or darkfield corrected, to obtain a brightfield image of the hologram image in the form of brightfield image data.

Preferably, the microscope system is configured such that the post processing method comprises the programmed step of
- performing a phase retrieval method using the hologram image data and/or brightfield image data of the hologram image for obtaining a phase image of the hologram image in the form of phase image data.

Preferably, the microscope system is configured such that the phase retrieval method comprises the programmed step of utilizing multiple shifted hologram images (diffraction patterns) of the microbial specimen contained in the culture chamber, wherein the multiple shifted hologram images were obtained by imaging the multiple hologram images using different positions of illumination, in particular by activating different microLEDs, to reconstruct the phase information.

Preferably, the microscope system is configured such that the programmed step of utilizing multiple shifted hologram images comprises the step of obtaining a set of N different hologram images, wherein the hologram images were obtained by illuminating the microbial specimen on the culture surface of the culture chamber using different microLEDs of the microLED array, wherein, in particular, the culture surface contains an overlapping area, which is imaged by each of the hologram images of the set.

Preferably, the microscope system is configured such that the post processing method comprises the programmed step of
- applying an algorithm for coded ptychography using the hologram image data or brightfield image data of the hologram image for obtaining a phase image of the hologram image in the form of phase image data.

Preferably, the microscope system is configured such that the post processing method comprises the programmed step of
- applying a point source algorithm, in particular, a reconstruction algorithm for spherical waves with a non-paraxial approximation, and/or applying a non-point source algorithm, in particular a parallel light source algorithm, in particular, a reconstruction algorithm for planar waves with a paraxial approximation.

Preferably, the microscope system is configured such that the culture surface is positioned in a second distance d2 to the camera sensor surface, or the coded surface, and the culture surface is positioned in a third distance d3 to the microLED array device,

wherein the third distance d3 is larger than the second distance d2 in the inserted position of the culture chamber, or wherein d2>=d3.

the post processing method being specifically adapted to take into account that d2 < d3 or, respectively, d2>=d3.

The invention is also related to a computing device, which is configured to receive a hologram image data representing a hologram image from a lensless imaging device according to the invention,
the computing device being programmed to execute a post processing method for reconstructing a microscope image of the of microbial specimen contained in the culture chamber from the hologram image data.

The invention is also related to a data storage device having stored hologram image data obtained by the lensless imaging device according to the invention, the hologram image data representing a hologram image, wherein preferably, the data storage device has stored a set of hologram image data, each hologram image data obtained by the lensless imaging device according to the invention, wherein the hologram images of the set were obtained by illuminating the microbial specimen on the culture surface of the culture chamber using different microLEDs of the microLED array of the lensless imaging device.

The invention is also related to a computer-implemented method of reconstructing a microscope image of microbial specimen contained in the culture chamber from hologram image data obtained by the lensless imaging device according to the invention, the hologram image data representing a hologram image.

The invention is also related to computer program comprising instructions which, when the program is executed by a computer, cause the computer to carry out the method of the invention.

The invention is also related to computer storage medium having stored the computer program of the invention.

Further preferred embodiments of the subject matters of the invention can be taken from the embodiments according to the figures and the figure description.
Fig. 1 schematically shows a lensless imaging device according to an embodiment of the invention and a cell culture chamber.
Fig. 2a shows the lensless imaging device of Fig. 1, indicating distances d1, d2 and d3.
Fig. 2b shows the lensless imaging device of Fig. 1, configured to have values of distances d1, d2 and d3 being different from those of Fig. 2a.
Fig. 3 shows an isometric view of a lensless imaging device according to another embodiment.
Fig. 4 shows the processing scheme of required and optional post processing steps, for obtaining a microscope brightfield and/or phase contrast image from the hologram image obtained by the lensless imaging device shown in Fig. 1 to 3.
Fig. 5 shows an isometric view of a microscope device according to an embodiment of the invention including a lensless imaging device according to an embodiment of the invention.
Fig. 6 schematically shows the electronic system with basic components for the microscope according to Fig. 5.
Fig. 7 shows microscope images for illustrating the rPIE (regularized Ptychographic Iterative Engine) used for post processing an hologram image for obtaining a microscope brightfield and/or phase contrast image from the hologram image obtained by the lensless imaging device shown in Fig. 1 to 3.
Fig. 8 shows the geometric setup of microLED sources and the camera sensor for deriving the equation for the loss of FoV from overlapping images.
Fig. 9 shows the impact of a varying number of images on the image quality of the reconstructed image, by pairwise showing the shifted positions of the microLED in an x-y-plane (right side), and the resulting reconstructed image (left side).
Fig. 10 shows six plots of intended LED positions for the different patterns that were tested for implementing the microLED array device of the lensless imaging device of Fig. 1 to 3.
Fig. 11 shows six plots of the actual LED positions for the different patterns that were tested for implementing the microLED array device of the lensless imaging device of Fig. 1 to 3.
Fig. 12 shows the front side (upper picture, containing the microLED array) and the backside of a microLED Board carrying the microLED array device of the lensless imaging device of Fig. 1 to 3.
Fig. 13 shows a collection of images and diagrams, showing the actual FoV of the microscope device in relation to the sample, shown on the left side inside a CC 500, the achieved FoV microscopic image, a zoomed in section of a smaller USAF groups 8 and 9, wherein across the red line the phase value of the acquired quantitative phase contrast image was measured and is also shown as plot.
Fig. 14a shows a phase contrast image, and an enlarged detail thereof in Fig. 14b, of a resolution target in a filled CC, obtained by the microscope device of Fig. 5.
Fig. 15 shows a phase value measured across Group 8 Element 2 as indicated by the marked line from Figure 14a, 14b.
Fig. 16 shows a microscopic standard image of a sample of biological cells.
Fig. 17 shows the phase contrast image obtained by the microscope of Fig. 5 based on a hologram image obtained for the sample in Fig. 16.
Fig. 18 shows an isometric view of an aerospace experimental module according to an embodiment including one or more lensless imaging devices and respectively, a microscope according to the invention.
Fig. 19 shows an isometric view of an aerospace experimental module according to another embodiment including one or more lensless imaging devices and respectively, a microscope according to the invention.
Fig. 20 shows an isometric view of an aerospace experimental module according to another embodiment including one or more lensless imaging devices and respectively, a microscope according to the invention.
Fig. 21 shows a container sleeve for the aerospace experimental module of Fig. 20.
Fig. 22 shows an isometric view of scientific container including multiple aerospace experimental module of Fig. 18 to 20.
Fig. 23 shows an isometric view of a random positioning machine carrying a microscope according to Fig. 5.

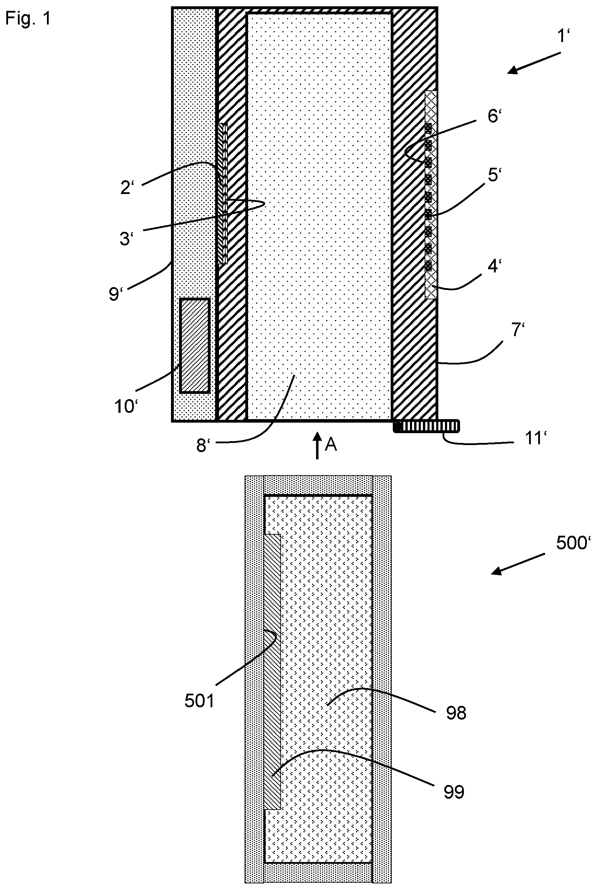

Fig. 1 shows a lensless imaging device 1' for obtaining a hologram image, carrying intensity and phase information, of microbial specimen 99, which are biological cells having a maximum measure between 5 and 120 µm, contained in a culture chamber (500; 500'), comprising a camera sensor device 2' having a camera sensor surface 3', a microLED array device 4' having individually controllable microLEDs 5', which are aligned along an LED array plane 6'; a holder device 7' for maintaining a relative position of the camera sensor device 2' and the microLED array device 4', creating a receiving space 8' between the camera sensor surface 3' and the LED array plane 6', the receiving space 8' being adapted to receive the culture chamber 500' and being adapted for allowing the transmission of light, which is emitted by the microLED array device 4', through the receiving space 8' and the culture chamber 500'; an electronic control device 9' for controlling the microLED array device 4' and the camera sensor device 2' and being programmed to perform an image capture process for obtaining a hologram image of the microbial specimen 99 contained in the culture chamber 500'; and a data storage device 10' for storing hologram image data obtained by the camera sensor device 2', the hologram image data representing the hologram image.

The culture chamber 500' is configured for positive fitting into the receiving space 8', and to be inserted therein by a sliding movement along the direction A which is in parallel to the LED array plane 6', which is in parallel to the camera sensor surface 3'. Once the culture chamber 500' is placed in the mounting position inside the receiving space 8', the position of the culture chamber 500' inside the receiving space 8' is fixated by a fixation device 11', which may be a locking device 11', in particular a snap-in device 11', which allows a releasable connection, here a snap-in connection between the culture chamber 500' and the holder device 7'.

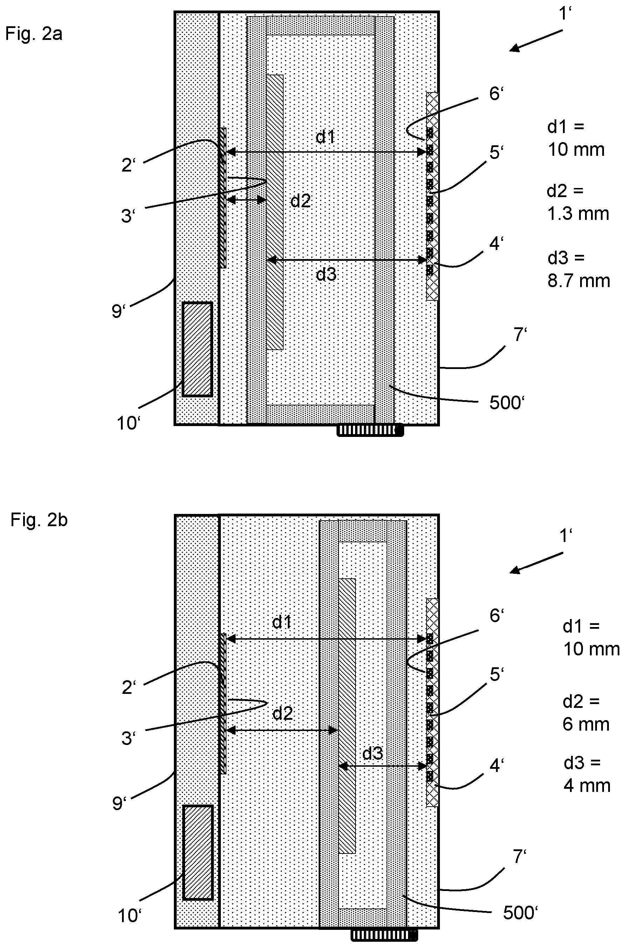

With reference to Fig. 2a and Fig. 2b, the camera sensor surface 3', which may be a coded surface, and the LED array plane 6' are separated by a first distance d1, which is 10 mm here, leading to a flat and compact assembly. The culture chamber 500' has a culture surface 501, configured for cell adhesion. In the mounting position of the culture chamber 500', the culture surface 501 is positioned in a second distance d2 to the camera sensor surface 3' and the culture surface 501 is positioned in a third distance d3 to the LED array plane 6' of the microLED array device 4', wherein the third distance is larger than the second distance in the inserted position of the culture chamber, in the configuration of Fig. 1 and Fig. 2a. In contrast, in the configuration of Fig. 2b, the second distance d2 is larger than the third distance d3 in the inserted position of the culture chamber 500'. A culture surface closer to camera surface, as shown in Fig. 2a, is easier on reconstruction and has a larger FoV, but less resolution, and a culture surface further away from a camera surface, as shown in Fig. 2b, has a smaller FoV but higher resolution due to the magnification effect of the point light source.

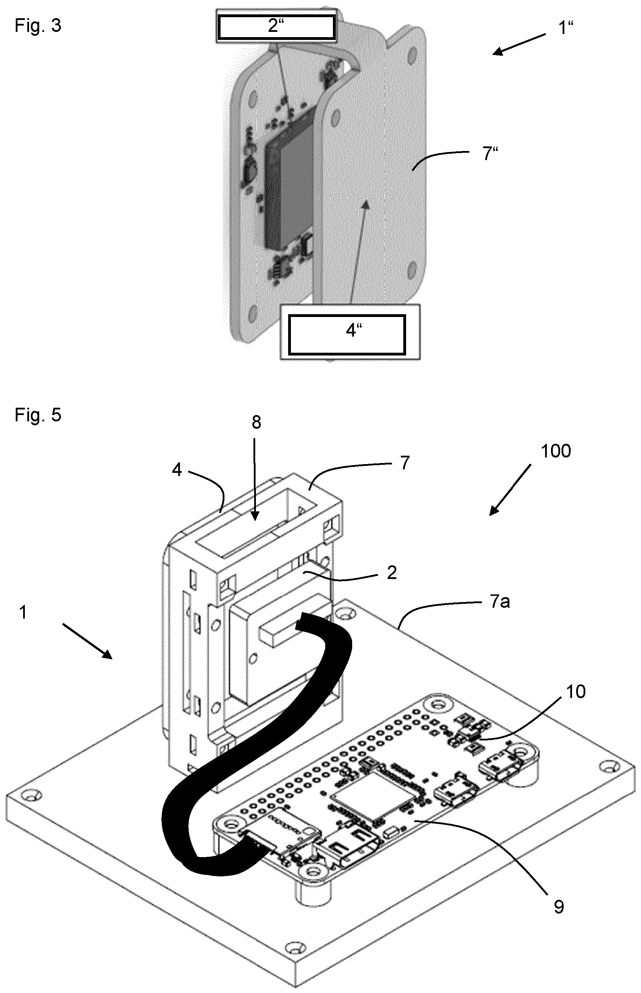

Fig. 3 shows an isometric perspective view of an embodiment of the lensless imaging device 1", which has an integrally U-shaped holder device 7", to which the microLED array device 4" and the camera sensor device 2" are mounted facing each other on opposing sides of the U-shaped frame 7".

Figure 5 show a preferred embodiment of a microscope 100 according to the invention, comprising an exemplary lensless imaging device 1, 1' according to the invention.

The camera sensor device 2, 2' includes a Sony IMX camera sensor having a pixel size of 1.85 µm and an effective pixel area of 3000x4000 pixels. This corresponds to a raw FoV of 41 mm². Together with the optical implications discussed hereinafter, the final FoV is expected to be 30 mm² for this design. On top of the cover glass of the camera sensor 2' a coded surface 3' as described hereinafter, is placed. The provided distances d1, d2, d3 are measured to the coded surface 3' and were also measured to the coded surface 3' in RD16. The distance between the camera sensor (coded surface) and the sample surface 501 shall be 1.3 mm for ideal image reconstruction and the expected FoV, the distance between the LED plane 6' and the camera sensor (coded surface) 3' is expected to be 10 mm. The base plate 7a and the holder device 7 from an integral holder device. The electronic control device 9, 9' board, including data storage 10, 10', is mounted to the base plate. The base plate may be mounted inside a container device or incubator device. The electrical connections from the camera sensor device 2, 2' and the microLED array device 4, 4' are not all shown.

The microscope 100, also referred to as microscope system 100, comprises a lensless imaging device 1, 1' and a computing device, implemented on the electronic board (PCB) indicated also e reference number 9, the computing device being configured to receive the hologram image data representing the hologram image and the computing device being programmed to execute a post processing method for reconstructing a microscope image of the of microbial specimen contained in the culture chamber from the hologram image data. It is noted that the basic capability of the electronic control device 9 is to retrieve the hologram image data representing the hologram image, thereby implementing the lensless imaging device 1, 1'. Adding the post processing capability (reconstruction from the hologram imaging data) provides the complete microscope, including the microscope image of the of microbial specimen contained in the culture chamber.

The post processing method, which is described exemplarily hereinafter in detail, comprises the programmed step of performing a phase retrieval method using the hologram image data or brightfield image data of the hologram image for obtaining a phase image of the hologram image in the form of phase image data. Herein, the phase retrieval method comprises the programmed step of utilizing multiple shifted hologram images (diffraction patterns) of the microbial specimen contained in the culture chamber, wherein the multiple shifted hologram images were obtained by imaging the multiple hologram images using different positions of illumination, in particular by activating different microLEDs, to reconstruct the phase information.

The microscope 100, which is based on the lensless imaging device 1, 1', shall be used to acquire live images of the target object of study, in particular living cells 99 contained in a liquid cell medium 98 contained in the culture chamber 500'. The lensless imaging device 1, 1', to be combined with the Culture Chamber (CC) 500', in which the sample is kept alive, have to be compact for spaceflight application. The overall space is limited by the experiment containers used to operate the experiment in space, which are e.g. limited to a internal volume of ~60x81x109 mm. To achieve this, the lens-less microscopy technology was selected and a compact assembly was chosen, as the space limitation does not allow the inclusion of complex mechanics or optics. The basic concept of lens-less microscopy is to use a small light source to illuminate the sample and acquire an image with a digital imaging sensor. As no lenses are used, the capture im-age is a diffraction pattern of the sample not a sharp image. To acquire a sharp bright field image, a post processing algorithms to propagate the diffraction pattern to the correct distance is used. As phase information is not directly capture by digital sensors, the phase information must be recovered in a separate post processing step, called phase retrieval. Sufficient computing power is provided for this purpose.

Characteristics of the microscope 100 using the lensless imaging device 1, 1' are the achievable field of view (FoV) of 30 mm² and the achievable resolution of 3 µm in phase contrast images (NEMUCO-ESR-020) while maintaining a low height (geometric extension perpendicular to the FoV). The microscope therefore has interfaces to the CC in a geometric and optical sense (optical path of the microscope must be transparent) and of course also has electronical interfaces, for power supply, command, and image storage.

### THEORETICAL BACKGROUND

The operating principle of the lensless microscope separates it into a brightfield imaging using holography and a phase retrieval to also recover phase information. Most lensless microscopes reported in literature feature only the first, holographic bright field imaging. This can be achieved with single images and is generally an easier to achieve implementation. For phase contrast imaging it is necessary to retrieve the phase information from the intensity only measurements, which requires an oversampling using multiple images (RD1: J. Dong, L. Valzania, A. Maillard, T. Pham, S. Gigan, and M. Unser, "Phase Retrieval: From Computational Imaging to Machine Learning: A tutorial," IEEE Signal Process Mag, vol. 40, no. 1, pp. 45-57, Jan. 2023, doi: 10.1109/MSP.2022.3219240).

The microscope 100 may be configured to impement holographic bright field imaging and preferably also a phase retrieval.

### Holographic Microscopy

The principle of lensless microscopy is digital in line holographic microscopy (DIHM) which is described in detail in (RD2: M. H. Jericho and H. Jürgen Kreuzer, "Point Source Digital In-Line Holographic Microscopy Digital In-Line Holographic Microscopy," 2011, pp. 3-30. doi: 10.1007/978-3-642-15813-1_1.).

Traditionally, lasers and pinholes were used to generate a point light source. As a preferred solution for a compact design, MicroLED arrays acvs point sources can be used (RD3: N. Franch et al., "Nano illumination microscopy: a technique based on scanning with an array of individually addressable nanoLEDs," Opt Express, vol. 28, no. 13, p. 19044, Jun. 2020, doi: 10.1364/OE.391497: RD4: A. Vilà, S. Moreno, J. Canals, and A. Diéguez, "A Compact Raster Lensless Mi-croscope Based on a Microdisplay," Sensors, vol. 21, no. 17, p. 5941, Sep. 2021, doi: 10.3390/s21175941; RD5: E. Prajapati, S. Kumar, and S. Kumar, "Muscope: A miniature on-chip lensless microscope," bioRxiv, p. 2021.06.09.447680, Jun. 2021, doi: 10.1101/2021.06.09.447680). This approach using MicroLED arrays is also called Nano Illumination Microscopy or NIM.

Within the holographic image reconstruction two different approaches must be differentiated, spherical light sources and parallel (plane) light sources. The spherical light source introduce a magnification effect which has an impact on the achievable resolution. The theoretic optimal achievable resolutions for both types of holography are (RD6: T. Latychevskaia and H.-W. Fink, "Practical algorithms for simulation and re-construction of digital in-line holograms," Appl Opt, vol. 54, no. 9, p. 2424, Mar. 2015, doi: 10.1364/AO.54.002424) ${R}_{planar} = \frac{λ}{2 ⋅ sin Θ}$ (1) ${R}_{spherical} = \frac{λ}{2 ⋅ \frac{Z}{z} ⋅ sin Θ}$ (2) referring to the wavelength of the utilized light λ, the distances Z (from point source to image plane) and z (from point source to object plane) and Θ the maximal possible angle of the scattered wave. This means for a point-source of light the resolution can be optimized by adjusting the distances Z and z correspondingly. The ratio Z/z is also called the magnification factor, as this ratio describes the amount of expected magnification. The point-source of light therefore enables the potentially higher resolutions although this would reduce the achievable field of view. However, at the same time the resolution is basically also improved accordingly (e.g. if the resolution is 2 µm with no magnification then it would be 1 µm with a magnification of 2).

In order to recover a sharp image from a hologram/diffraction pattern it is necessary to use Fourier theory and so called propagators to propagate the captured holograms to the distance where the sample is located. Through this propagation, it is possible to recover a sharp image. RD6 provides a detailed overview of the corresponding algorithms for this propagation for different use cases. A short summary of the most relevant aspects of the theory from RD6 is provided here for clarity.

An object in the optical path can generally be described by a transfer function *t*(*x, y*)*.* $t \left(x, y\right) = {e}^{- a \left(x, y\right)} {e}^{i ϕ \left(x, y\right)}$ (3) where *a*(*x, y*) describes the absorption and ϕ(x, y) the phase distribution of the object. The light wave exiting the object can then be described as. ${W}_{exit wave} \left(x, y\right) = {W}_{incident} \left(x, y\right) ⋅ t \left(x, y\right)$ (4)

This exit wave then propagates from the object plane (*x,y*) to the detector plane (*X,Y*). Following the Angular Spectrum Method, which is one of the most commonly and powerful scattering theories, the wave at the detector can be described as. ${W}_{detector} \left(X, Y\right) = {FT}^{- 1} \left[FT\left(t\left(x, y\right)\right)⋅{e}^{\frac{2 πiz}{λ} ⋅ \sqrt{1 - {\left(λu\right)}^{2} - {\left(λv\right)}^{2}}}\right]$ (5)

Where *FT* denotes a fourier transform, *FT*^{*-*1} an inverse fourier transform, *z* the distance between the object and the detector, *λ* the wavelength of the light and *u* and *v* coordinates in the fourier space. The term ${e}^{\frac{2 πiz}{λ} ⋅ \sqrt{1 - {\left(λu\right)}^{2} - {\left(λv\right)}^{2}}}$ can also be termed a propagator used to calculate the free space propagation of the wave. In order to reconstruct a hologram the following steps are therefore necessary.
a) Calculate Fourier Transform of the captured hologram
b) Calculate propagator ${e}^{\frac{2 πiz}{λ} ⋅ \sqrt{1 - {\left(λu\right)}^{2} - {\left(λv\right)}^{2}}}$
c) Multiply results of a) and b)
d) Calculate the inverse Fourier Transform of the result of c)

### Phase Retrieval

Capturing phase contrast images with the microscope is preferred; two different types of phase image acquisition can be distinguished. One type is the qualitative phase contrast image, which is acquired through optical microscopes and only provides qualitative information (with lighter or darker parts in the images). This approach usually requires lenses and other optical devices to generate two phase shifted light waves using interference of these waves to make the phase shift visible. An alternative approach is quantitative phase contrast microscopy which uses digital images and phase retrieval algorithms to quantify the phase information. Overall, it can be summarized that quantitative phase retrieval contains more information and therefore will be the preferred solution compared to qualitative implementations (RD7: C. Wang, Q. Fu, X. Dun, and W. Heidrich, "Quantitative Phase and Intensity Microscopy Using Snapshot White Light Wavefront Sensing," Sci Rep, vol. 9, no. 1, p. 13795, Dec. 2019, doi: 10.1038/s41598-019-50264-3).

A good overview on the theory of phase retrieval is provided by RD1. The underlying mathematical problem of phase retrieval can be described as (RD1): $I = {\left|AW\right|}^{2}$ (6)

Where *I* represents the acquired raw images which are only intensity measurements and therefore real numbers. ***A*** is a complex valued measurement matrix which describes the imaging process and depends on the utilized experimental setup and *W* corresponds to the complex valued incident wave at the detector (previously also *W_{detector}*(*X, Y*) but for simplicity here called W). The phase retrieval problem is the search for the complex valued *W* while only the real valued *I* is known. With only a single measurement *I* there is no unique solution for this problem. For a unique solution the number of required images in 2D is four images, whereas for 3D it requires 8 images, according to RD1. For a perfect solution, the number of images are eight (2D) and twelve (3D) respectively, according to RD1. However, in many use cases a good reconstruction is feasible with less images than the theoretically required ones according to RD1.

If the intended use case of the microscope shall not be limited to only 2D samples, the minimum number of images that shall be captured can therefore be considered to be 12, in order to have a change for theoretically perfect phase retrieval.

The search for *W* can then be described as an optimization problem, since $I - {\left|AW\right|}^{2} = 0$ (7)

An estimate for W called *Ŵ* must minimize the function *I -* |*AŴ*|² which can be handled as a global non-linear optimization problem. One popular algorithm to solve this optimization problem is the Ptychographic Iterative Engine (PIE) according to RD1. RD8 provides an overview and comparison of different implementation for PIE, in particular mPIE (RD8: A. Maiden, D. Johnson, and P. Li, "Further improvements to the ptychographical iterative engine," Optica, vol. 4, no. 7, p. 736, Jul. 2017, doi: 10.1364/OPTICA.4.000736.). One of the basic implementations is the ePIE (enhanced Ptychographic Iterative Engine) algorithm which can be described as: ${W}_{i + 1}^{j} = {W}_{i}^{j} + α ⋅ \frac{{P}_{i}^{∗} ⋅ \left({E}_{i}^{′}-{E}_{i}\right)}{{\left|{P}_{i}\right|}_{max}^{2}}$ (8)

| | | | |
|---|---|---|---|
| ${W}_{i}^{j}$ | i-th image and j-th iteration Object | *α* | Step Size |
| *P* | j-th image Probe | E*ᵢ* | Exit wave of sample |
| ${E}_{i}^{′}$ | propagated exit wave | | |

The * indicate the complex conjugate of the value whereas II indicates the absolute value and the index max corresponds to the maximum. ePIE first loop through all available images and then starts again for the next iteration step *j* after all images have been processed. What can serve as a probe for the ePIE depends on the experimental setup.

### Post Processing Software

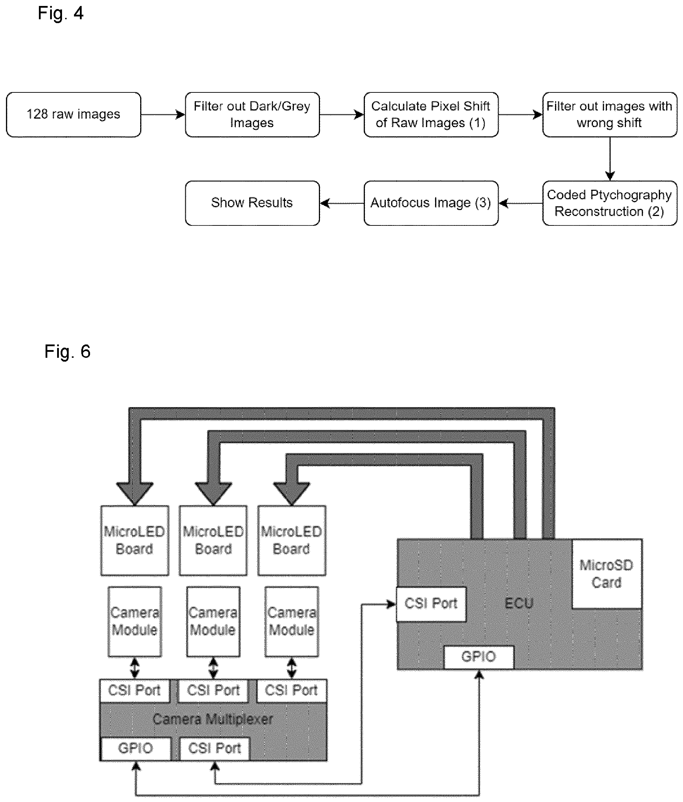

Since the NIM microscopy does not directly produce viable microscopic images it is necessary to first discuss the various post processing steps to also understand the design decisions made for the NIM microscope discussed in the later chapters. Fig. 4 provides an overview of the required and optional post processing steps, as used here.

The preferred choice of coded ptychography as the utilized reconstruction software was found a suitable solution after the conduction of multiple tests. Generally, another implementation of quantitative phase contrast is fourier ptychography which utilizes an LED array and a phase retrieval algorithm to generated quantitative phase contrast images but also utilizes an optical microscope with lenses (RD17: M. Chen, Z. F. Phillips, and L. Waller, "Quantitative differential phase contrast (DPC) microscopy with computational aberration correction," Opt Express, vol. 26, no. 25, p. 32888, Dec. 2018, doi: 10.1364/OE.26.032888.). RD14 provides a comparison of fourier ptychography and coded ptychography (RD14: S. Jiang et al., "Spatial- and Fourier-domain ptychography for high-throughput bio-imaging," Nat Protoc, vol. 18, no. 7, pp. 2051-2083, Jul. 2023, doi: 10.1038/s41596-023-00829-4.). There are also alternative phase retrieval approaches like e.g. the PtychoPy framework which implements three different possible algorithms (RD18: K. Yue, J. Deng, Y. Jiang, Y. Nashed, D. Vine, and S. Vogt, "Ptychopy: GPU framework for ptychographic data analysis," Jan. 2022, [Online]. Available: http://arxiv.org/abs/2202.03144).

The coded ptychography reconstruction is the core of the reconstruction process and described in detail in RD14. The coded ptychography described in RD14 utilizes a coded surface as the probe for the Ptychographic Iterative Engine. This coded surface can be a thin mono-layer of blood cells, a glass surface with phase and intensity scatters (RD11: S. Jiang et al., "Resolution-Enhanced Parallel Coded Ptychography for High-Throughput Optical Imaging," ACS Photonics, vol. 8, no. 11, pp. 3261-3271, Nov. 2021, doi: 10.1021/acsphotonics.1c01085.) or a thin PDMS film with microparticles (RD19: R. Wang et al., "Spatially-Coded Fourier Ptychography: Flexible and Detachable Coded Thin Films for Quantitative Phase Imaging with Uniform Phase Transfer Characteristics," Adv Opt Mater, vol. 12, no. 15, May 2024, doi: 10.1002/adom.202303028.). For the microscope 100 of the embodiment, the glass coded surface is selected due to high stability and no addition of biological substances.

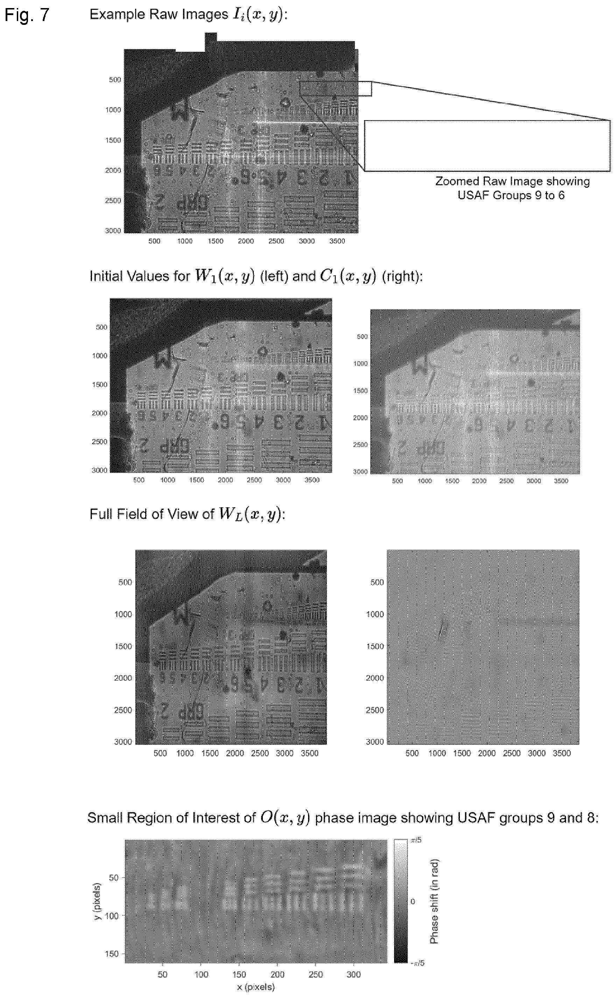

The coded ptychography reconstruction shown in steps 1 to 28 below, with reference to Figure 7, utilizes the rPIE (regularized Ptychographic Iterative Engine) algorithm to solve the phase retrieval, which was replaced by the efficient mPIE (momentum-accelerated Ptychographic Iterative Engine) implementation from RD8 for the implementation of the microscope 100. 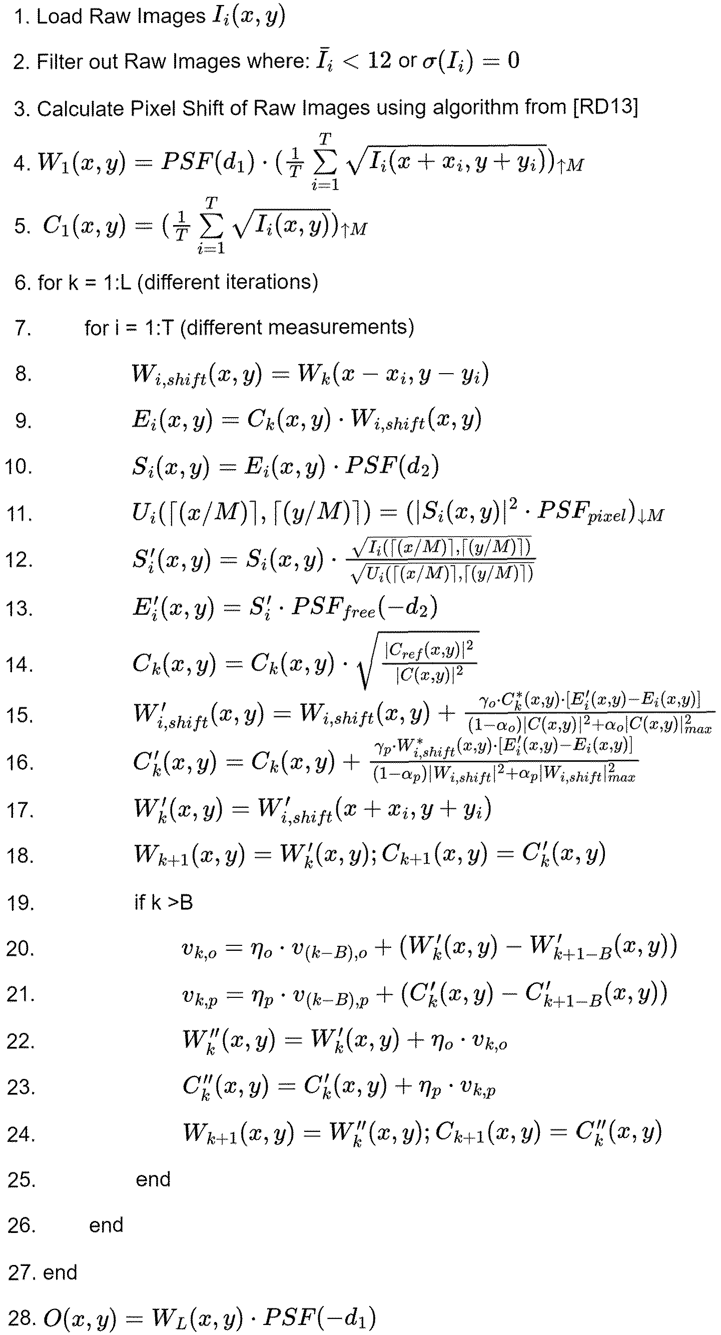
Re. 4.: Initialize object wavefront W₁(x, y) on the coded surface plane
Re. 5.: Initialize Coded Surface Profile
Re. 8.: shift the wavefront based on the estimated shifts
Re. 9.: exit wave at the coded surface plane
Re. 10.: propagate the exit wave to the sensor plane
Re. 11.: Down-sample the intensity image on the sensor plane
Re. 12.: Update S*ᵢ(x*, y) on the sensor plane
Re. 13.: propagate the field back to the coded surface
Re. 14.: power correction of the coded surface
Re. 15.: PIE iteration step for wavefront, depending on parameters for ePIE, rPIE or mPIE
Re. 16.: PIE iteration step for coded surface, depending on parameters for ePIE, rPIE or mPIE
Re. 17.: shift back the updated wavefront
Re. 18.: A update object wavefront and coded surface for next iteration
Re. 20.: velocity map for the object wavefront
Re. 21.: velocity map for the coded surface
Re. 22.: momentum based update of object wavefront
Re. 23.: momentum based update of coded surface
Re. 24.: update object wavefront and coded surface for next iteration
Re. 28.: propagate the exit wavefront to the object plane

The advantages of rPIE and mPIE are better convergences and less likelihood to become stuck in local minima of the optimization problem (RD8). In addition, mPIE was conceived to solve "pathologically difficult cases" (RD8). rPIE adjust the update routine of ePIE as follows: ${W}_{i + 1}^{j} = {W}_{i}^{j} + \frac{{P}_{i}^{*} ⋅ \left({E}_{i}^{′}-{E}_{i}\right)}{\left(1-α\right) ⋅ {\left|{P}_{i}\right|}^{2} + α ⋅ {\left|{P}_{i}\right|}_{max}^{2}}$ (9)

Whereas the adjustment from mPIE is the addition of momentum to the update routine by calculating a velocity map: ${v}_{j} = η ⋅ {v}_{i - T} + \left({W}_{i + 1}^{j}-{O}_{i + 1 - T}^{j}\right)$ (10)

| | | | |
|---|---|---|---|
| *vᵢ* | i-th image velocity map | *η* | Step Size |
| *T* | initial steps to skip momentum | | |

In a deviation from the original momentum implementation, the momentum is currently not applied for all images, but after the reconstruction from all images is finished and before the next iteration loop I is started.

In addition, the power constraint described in the supplement of RD8 was implemented as an improvement. RD14 also describes a calibration step for which 1500 raw images are captured using blood cells as a sample to pre-calculate the coded surface. However, in tests with the intended NEMUCO sample after implementing the improvements, this calibration proved unnecessary as the same results could be achieved without it. Therefore, the calibration is neglected for the YuriScope post processing and instead the steps described as (calibration only) in 5 are performed for each calculation. The adjustments to the algorithm were necessary because the reported coded ptychography setup utilizes a laser light source and stepper engines to acquire shifted images (RD14), which results in an overall relatively large setup. For the setup of microscope 100 as shown in 5 this was adjusted to instead utilize a MicroLED array as light source which also results in slightly shifted images. The specific design of the MicroLED array is discussed below. While RD14 reported that about 300 raw images are required for phase retrieval after the calibration the adjusted implementation of the microscope 100 can achieve phase retrieval with less than 30 raw images.

In comparison to the holographic propagation the utilized reconstruction process with multiple images also improves the image quality for bright field samples, as shown in Figure 7 in comparison with steps 1 to 28, which uses a single image and propagates it.

The power correction was implemented as it was noticed that for higher number of iterations the algorithm is instable as the probe intensity changes over the iterations. By implementing the power correction, the algorithm is stable also for high number of iterations. The advantage of this is a better image quality also for a low number of raw images.

### Field of View

The FoV of the microscope 100 depends not only on the provided FoV of the camera sensor but also on the overlap of the individual images used in the post processing and the magnification effect. As this impacts the design of the MicroLED array and the camera sensor, the FoV impacts are discussed in detail.

If the same distances as in Figure 3 are defined the FoV from a single LED can be calculated according to the following equations. ${A}_{FoV} = {x}_{FoV} ⋅ {y}_{FoV}$ (11) ${x}_{FoV} = \frac{z}{Z} ⋅ {x}_{camera}$ (12) ${y}_{FoV} = \frac{z}{Z} ⋅ {y}_{camera}$ (13)

Therefore, the FoV overall can be calculated to: ${A}_{FoV} = {\left(\frac{z}{Z}\right)}^{2} ⋅ {A}_{camera}$ (14)

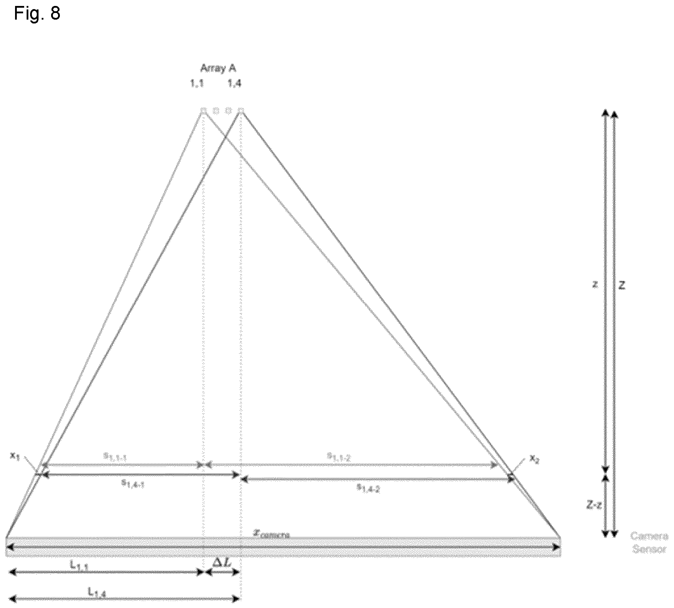

The FoV area for each individual image as described by equation (14) is reduced further as multiple images are combined into a super resolution or phase contrast image. The loss of FoV from the overlapping of multiple images is a bit more complex to calculate. A general calculation for this is derived based Figure 8, which shows the required geometric consideration for an individual LED array. The loss in FoV corresponds to the distances *x*₁ and *x*₂ which are the distances between the outer edges of the two overlapped FoVs. ${x}_{1} = {s}_{1 , 1 - 1} - {s}_{1 , 4 - 1} - Δ L$ (15) ${x}_{2} = {s}_{1 , 4 - 2} - {s}_{1 , 1 - 2} - Δ L$ (16)

The distance Δ*L* depends on the pixel pitch or additionally the pitch between the LED arrays. In the shown example for the outer two LEDs of a 4x4 LED array the parameter corresponds to Δ*L* = 3 · Δ*dₚᵢₓₑₗ* with Δ*dₚᵢₓₑₗ* as the pixel pitch of the LED array. The other required length can be calculated from the size of the camera sensor (*x_{camera}*) and the previously used distances *z* and *Z*. ${s}_{1 , 1 - 1} = {L}_{1 , 1} ⋅ \frac{z}{Z}$ (17) ${s}_{1 , 1 - 2} = \left({x}_{camera}-{L}_{1 , 1}\right) ⋅ \frac{z}{Z}$ (18)

Overall if equations (15) to (18) are inserted into each other it can be derived that the distances *x*₁ and *x*₂ can be described as: ${x}_{1} = {x}_{2} = Δx = Δ L ⋅ \left(1-\frac{z}{Z}\right)$ (19)

With this the loss in FoV from overlapping images only depends on the geometric parameters again. And if this loss in FoV for the distances is converted into the loss for the area it results in the following equation (assuming the distance in x, and y direction between the taken image is identical to be Δ*L* therefore resulting in the same shift of Δx). ${A}_{FoV , overlapped} = \left({x}_{FoV}-Δx\right) ⋅ \left({y}_{FoV}-Δx\right)$ (20)

The length Δx is only subtracted once in both directions, because it is subtracted from the FoV dimension of a single image. In one picture the length x₁ will be lost and in the other picture the length x₂ will be lost through overlapping. But overall, the overlapping image will have the dimension *x_{FoV} -* Δx*.*

### MicroLED Array design definition

Within the LED display system element, the MicroLED array is used to generate multiple different raw images to provide them to the post-processing. As coded ptychography was chosen as the post processing algorithm based on the tests performed in RD16, the discussed MicroLED array design is optimized for this algorithm.

### Pixel Size

Regarding the size of the MicroLEDs. As discussed before, a point source of light enables the utilization of magnification to improve the resolution. There is no exact available definition on when a light source can be considered a point source, e.g. RD5 utilized MicroLEDs with the size of 1.7 µm and were able to achieve point sources. RD2 also states that the pinhole diameter used in DIHM to generate spherical waves is usually 1 µm which means it can be expected that the light source should be as close as possible to 1 µm in size.

It was found that using the 1 µm LEDs is possible, however, the luminosity of the 1 µm is quite small, as the luminosity scales with the area of the LED. Eventually, 5 µm LEDs were utilized, which can be operated reliably at 5 V.

### Pixel Pitch

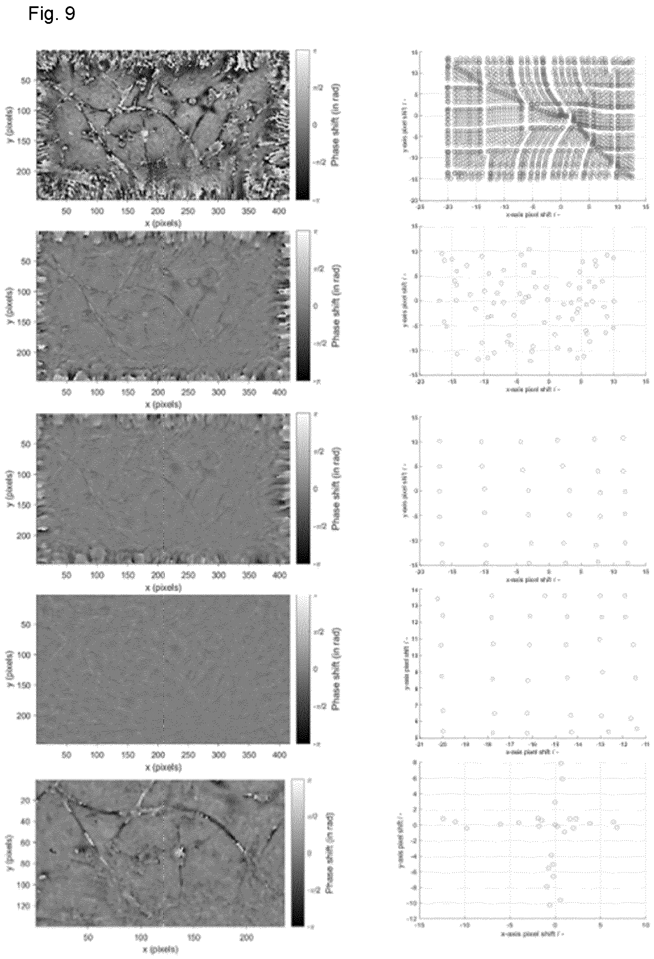

Regarding the pixel pitch of the MicroLED array. A microscope setup with stepper engines was used for testing and for simulating different LED arrays. For this purpose, it was adjusted to reposition the LED array instead of the camera sensor with the stepper engines. The resulting setup is shown in Figure 9. Multiple tests were performed to minimize the required number of LEDs as a large number of LEDs results in a more complex electronical setup and higher required data budgets. Further tests were performed to select a suitable pattern for the MicroLEDs which is manufacturable but also results in good image quality results.

Figure 9 shows a comparison of different LED patterns which were tested in RD16 starting with a large spiral style image acquisition based on the approach described in RD14 reaching a matrix style approach with 36 images. The final image shows an approximate cross shape for LEDs with an optimized image processing algorithm (implemented power correction with more iterations) and represents the final solution. In particular Fig. 9 shows results showing the impact of a varying number of images. The first four results from the top are from the test performed within RD16 using 100 iterations and mPIE without power correction. The last image shows the result for 1000 iterations with power correction using 27 images roughly in cross orientation. All images were acquired using a single LED that was repositioned with stepper engines.

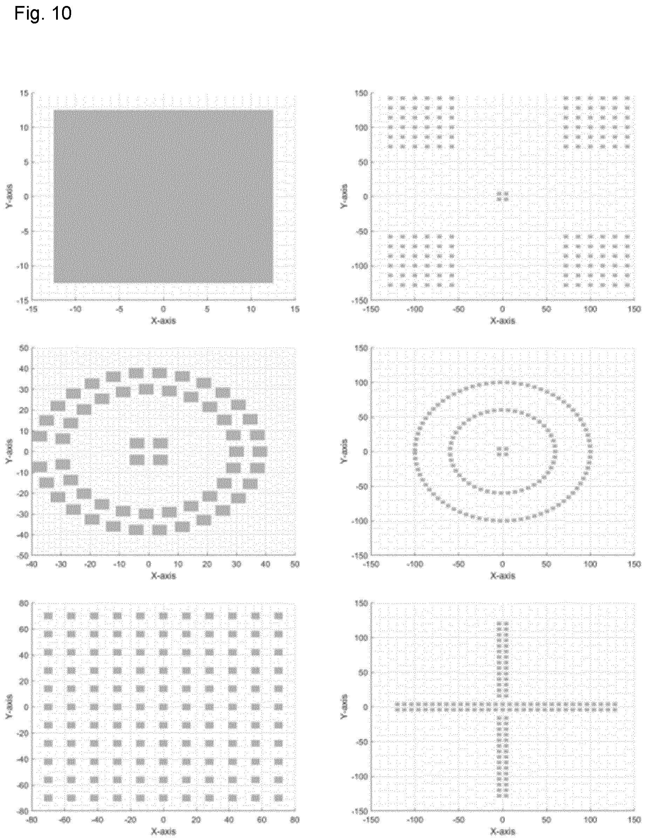

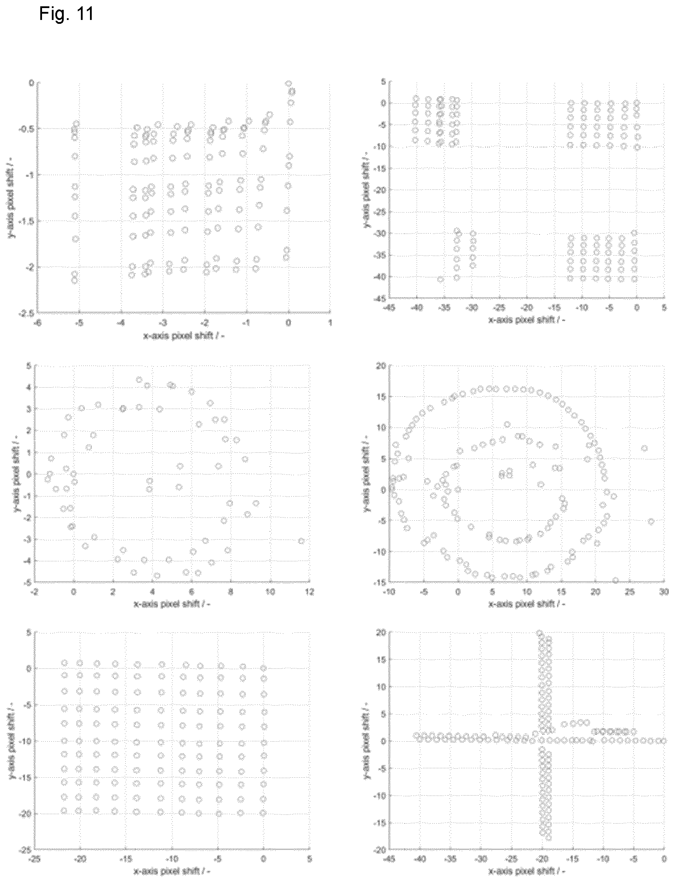

The cross shape for the image acquisition was derived in a separate test series after RD16. For this test series multiple different patterns were simulated and a phase only resolution target was imaged to quantify the effect of the different patterns on the achievable resolution. Figure 10 shows the intended positions of the LEDs, whereas Figure 11 shows the resulting actual positions which are not fully accurate due to inaccuracies on the stepper engines. In Figure 10, plots of the intented LED positions for the different patterns are shown that were tested. Quadrats show the 5 µm large MicroLEDs to scale to the selected pixel shift between the LEDs.

Tests showed that optimal results are achievable for a 11x11 matrix with only 2 µm, which is closest to the way the system in RD14 is operated. Since a 2 µm pitch with 5 µm sized LEDs was only feasible while using stepper engines, this pattern was therefore only acquired for comparison purposes. The closest results to this are achieved for the two different circle patterns and the cross shaped pattern. Indeed, the results on the circles and the cross are nearly indistinguishable from a resolution perspective. The preferred pattern is the cross shape, wherein the routing of the lines to the LEDs is easiest to achieve. Also a circle shape is possible, where the spacing between the LEDs may be small to achieve the two concentric circles. The number of LEDs was selected to be 128 to simplify the electrical design and enable the operation of the LEDs through I2C GPIO expanders. Even though it was shown that the algorithm can achieve satisfactory results with less LEDs, generally more images lead to better results. In addition, the selected number of LEDs still results in a functional system in case not all LEDs work.

### Camera Sensor

The preferred physical parameters of the optical sensor-field of view (FOV) greater than 30 mm² and a pixel size below 3 µm - are related to the sample standard NEMUCO-ESR-020. The goal is to achieve high-resolution imaging with a sufficiently large FOV for effective image capture. However, in practice, there is trade-off between resolution, power consumption, and ease of implementation as a technical condition for the camera selection.

High-resolution, high-FOV camera chips are generally optimized for speed and data throughput, often without consideration for low power consumption, making them less suitable for embedded systems with constrained power budgets, which is the case for spaceflight applications. For the present embodiment, the VC MIPI IMX226 was selected after a comprehensive trade-off analysis due to its balance of high resolution, small pixel size, compatibility with the MIPI CSI2 interface, and ease of integration. However, other high-performance camera chips may be considered. The VC MIPI IMX226 provides the optimal solution, offering high-quality imaging with minimal development overhead, making it the most suitable choice for the microscope's optical sensor system.

### Coded Surface

There are multiple options for coded surfaces. It may be, for example, a thin mono-layer of blood cells (RD14), a glass surface with phase and intensity scatters (RD11) or a thin PDMS film with microparticles (RD19). For the present embodiment, the glass coded surface was selected due to high stability and no addition of biological substances. Therefore, the glass based coded surface as described in RD11 was therefore selected. The manufacturing process for these coded surfaces is described in the supplement of the paper RD11. During tests the thin PDMS was also utilized in some runs.

### Electronics

Several options were evaluated for electronically interfacing with the camera module and managing the system's overall control.

ECU: The Raspberry Pi Zero 2W was selected as the most viable option due to the following factors:
1) Power and Performance: The Raspberry Pi Zero 2W, powered by an ARM Cortex-A72 processor, provides sufficient computational capability to handle image capture and processing tasks. The integrated MIPI CSI2 port enables direct interfacing with the camera module, making it highly suitable for image acquisition in the microscope system.
2) Form Factor: The Raspberry Pi Zero 2W features a compact form factor, with dimensions of 65mm x 30mm, making it ideal for space-constrained designs. Its small size allows easy integration into the microscope system.
3) Scalability and Flexibility: The Pi offers a flexible platform for future enhancements or expansions, allowing for additional functionalities such as networking, external storage, or real-time data processing.
4) Development Ecosystem: The Raspberry Pi benefits from a robust development eco-system with extensive software support, making it easier to implement, test, and optimize the imaging system without requiring substantial custom R&D effort.

The Raspberry Pi was deemed manageable within the overall power budget, making it a practical and effective choice for this application.

Camera Multiplexer: The Arducam V2.2 camera adapter was selected for the microscope system for the following reasons:
1) Multi-Camera Support: The Arducam V2.2 camera adapter enables the use of multiple camera modules with a single MIPI CSI2 interface on the Raspberry Pi. This functionality is relevant for applications that require capturing images from different viewpoints or sequentially switching between multiple cameras, as in multi-channel microscopy.
2) Compatibility: The Arducam V2.2 adapter is fully compatible with the Raspberry Pi's CSI interface and supports standard camera modules, such as the Raspberry Pi Cam-era Module and other MIPI CSI2-compliant cameras. This compatibility eliminates the need for custom hardware development or complex interfacing solutions, making it an ideal off-the-shelf component.
3) Ease of Integration: The adapter is designed for seamless integration with the Raspberry Pi, ensuring smooth communication between the embedded controller and the camera modules. It simplifies the system architecture, allowing straightforward implementation of multi-camera setups without extensive modifications to the base system.
4) Form Factor and Size: The Arducam V2.2 camera adapter has a compact design, making it well-suited for space-constrained projects like microscopes. Its small foot-print allows it to fit neatly alongside the Raspberry Pi and other components without adding significant bulk to the system.
5) Cost-Effectiveness: As a commercially available, cost-effective solution, the Arducam V2.2 adapter reduces the overall cost of the system by providing a ready-to-use multi-camera interface. This negates the need for expensive custom solutions or additional hardware development, keeping the project within budget.
6) Development Ecosystem: Arducam offers comprehensive software libraries and sup-port for the Raspberry Pi, facilitating the easy configuration and control of multiple camera modules. This comprehensive ecosystem allows for quick development, testing, and troubleshooting, minimizing R&D time.

### Electronics design trade-offs:

### Embedded Control Unit

For the control and harmonization of the other system elements, multiple choices may be considered, for example the Raspberry Pi (or similar) processor or the Arduino (or similar) microcontroller. While an Arduino-style microcontroller may be more power-efficient and simpler to implement, the Raspberry Pi Zero 2W was selected for its superior processing power, integrated MIPI CSI2 interface, and overall versatility. The Raspberry Pi Zero 2W strikes the right balance between performance and system compatibility, making it a preferred choice for the present embodiment of the microscope. Additionally, the Pi Zero 2W's ability to handle more complex tasks positions it as a scalable solution, should additional functionality or processing power be required in future system iterations.

### Microscope electronic concept

Based on the trade-offs previously presented, the concept of an electronic system depicted exemplarily in Figure 6 represents the electronics connections for the single microscope 100 according to the embodiment. The microscope electronic concept is composed here by four main parts, the Embedded Controller unit (ECU) with the external non-volatile memory item, the Camera module, the Camera Multiplexer and the MicroLED board. The ECU interfaces with the Camera multiplexer through its GPIO pins and the CSI port, communicating also using the I2C protocol. The ECU is responsible to process external commands, trigger the whole image capturing process and store the data on the SD card. The four main parts are part of the embodiment of the electronic control device 9.

### ECU microcontroller selection

The Raspberry Pi Zero 2W was used, while other solutions are possible, for example using microcontrollers like the SAMD21, used in boards such as the Adafruit Feather M0, which offer low power consumption and a simplified design. The Raspberry Pi Zero 2W was selected as the optimal solution due to its superior processing power, built-in camera interfacing, and broader support for complex tasks in the present system.

### MicroLED array of the LED display selection

The MicroLED array was a solution provided by QubeDot GmbH, Braunschweig, Germany.

### MicroLED board Electronics

The MicroLED board of the embodiment consists of 128 MicroLEDs which would be switched on individually in sequence per image capture. The MicroLED board also consists of 8 MCP23017 GPIO Ex-panders each having 16 Input or output pins. This results in a total of 128 pins that when set as an out-put, can drive all the MicroLEDs on the MicroLED board. The Raspberry Pi communicates with the MicroLED board using the I2C protocol. The power to the MicroLED board is supplied through a load switch, which activates the board's electronics when an Enable signal (3.3V to 5V DC) is received. The MicroLED board electronics also consist of a 3.3V DC output Low Dropout Regulator (LDO) and an I2C level shifter to allow the I2C communication to take place at 5V DC between the ECU and the GPIO expanders.

### Hardware design MicroLED board Electronics

The implementation of the microscope may be planned to be divided into three main boards, one which is the ECU being responsible for general control of the process and for the image capturing, the second which is the Camera multiplexer providing an interface between the ECU and the three camera modules and the third, the MicroLED board.

### MicroLED board design

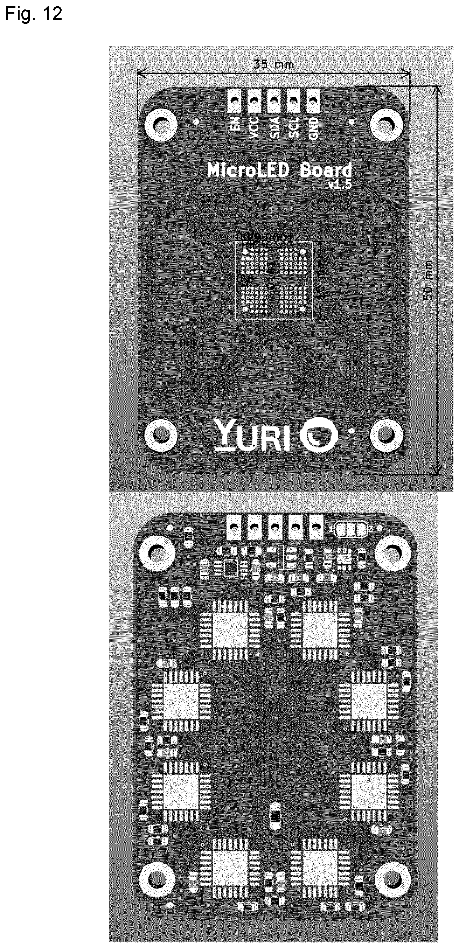

The configuration shown in Fig. 12 was realized in KiCAD for the MicroLED Board. The MicroLED Board was manufactured with 4 layers with a total thickness of 1,55mm. The copper thickness in the inner and outer layers is 35µm.

### Microscope Working Principle

The Raspberry Pi Zero 2W which is the ECU supplies power to all the microscope electronics in the microscope 100, namely the Camera Multiplexer, the MicroLED Boards, and the Camera Module. The power to the Camera Multiplexer is provided by the 3.3V power pins on the Raspberry Pi. The Camera Multiplexer communicates with the Raspberry Pi through the I2C Bus and receives commands through the I2C bus and the GPIO pins of the Raspberry Pi. The Camera Multiplexer achieves image transfer between the connected camera modules through the CSI ports present on the Camera Multiplexer and the Raspberry Pi.

### Flight Software

An operating software is used to operate the microscope 100 - the operating software not including the post processing of images. The software for the setup is divided into three parts:
Microscope Camera module control

The purpose of this software is to enable communication between the camera module and the Raspberry Pi using the physical interface between them. The software can modify the camera module's configuration and can set the camera into different camera acquisition modes. The software provides a trigger to initiate an image acquisition after which the im-age is stored onto the MicroSD card of the Raspberry Pi. The software parallelly interfaces with the microscope's MicroLED control software, to control the switching on and off of the MicroLEDs.

### Microscope Multi Camera module control

The purpose of this software is to enable communication and interfacing between the Raspberry Pi and multiple (2 to 4) Camera modules using the Camera Multiplexer along with the added functionality of the software described in section microscope Camera module control.

### Microscope MicroLED control

The purpose of this software is to control the MicroLEDs on the MicroLED board, allowing for the MicroLEDs to be switched on or off in response to a command.

### Working of microscope software

As the microscope is primarily controlled by a Raspberry Pi which uses a Linux based operating system, a software interface first needs to be created between the Raspberry PI and the camera sensor being used (VC MIPI IMX226). The manufacturer of the camera sensor, Vision Components, provides instructions to install and load the drivers and device tree overlays to operate the camera through the Raspberry Pi. Apart from the camera sensor, the microscope also consists of a MicroLED Board that consists of a load switch that upon receiving a GPIO high signal on its Enable pin, switches on electronics on the MicroLED board.

By configuring all the pins of the 8 MCP23017 GPIO expanders as outputs, all 128 of the MicroLEDs on the MicroLED board can be driven. The software uses the I2C protocol to communicate with the MicroLED board.

The microscope software simultaneously switches on one MicroLED and capture an image when the LED is illuminated. This process is repeated for all 128 MicroLEDs on the MicroLED board giving us a total of 128 images in a capture sequence.

The software is initialized by connecting to both the modules of the microscope 100, namely the MicroLED board and the VC MIPI IMX226 camera sensor. The Raspberry Pi sends a high signal from one of its GPIO pins that is connected to the Enable pin, switching on the MicroLED board. The addresses of the MCP23017 GPIO expanders are recognized by the software and the connection is this initialized. The pins (16 per GPIO expander) are then set as outputs.

A camera stream is initialized to enable the control of the camera through the microscope software. As part of the initialization sequence, the frames per second parameter and the gain parameter of the camera sensor are hard-set to ensure consistency of the camera during the image capture sequence.

Each MicroLED board has a csv file that contains the exposure time with respect to a certain LED in which the exposure time of the camera sensor is set to acquire an image of the illuminated target. During the initialization, the csv file is opened by the program and all the data in the file is read and stored in arrays to enable instant access to the LED number and the exposure time for the MicroLED.

If the initialization of the hardware of the microscope is not successful, the program throws an error and the program is terminated. This throwing of an error can be converted to a Status flag when the microscope 100 is implemented in a larger system and hence measures can be taken such as rebooting the Raspberry Pi to restart the initialization of the microscope Hardware.

When an image capture sequence is initialized, the first row of the csv file(which is stored in the first row of the pre-loaded array in the program) which contains the number of the MicroLED and its respective exposure time, is read and the program uses the number of the MicroLED is used to illuminate that specific MicroLED. Simultaneously the exposure time parameter is set in the camera, followed by the camera sensor capturing an image and storing it on the MicroSD card of the Raspberry Pi. The MicroLED that was illuminated is then switched off, and the next row of the csv file is then read, followed by the same process mentioned previously i.e., the respective MicroLED is illuminated followed by the exposure time being set in the camera, followed by an image being captured and saved to the MicroSD card of the Raspberry Pi, followed by switching off the previously illuminated MicroLED. This process is repeated for all the MicroLEDs on the board, resulting in a total of 128 images.

### Extended Functionality

The above section elaborates the control of the 1 microscope unit using a Raspberry Pi. In applications where the total space available is a constraint, requiring the use of multiple microscope through one Raspberry Pi. In such an application, a camera multiplexer that has multiple MIPI-CSI ports is used.

A total of four microscopes, or respectively lensless imaging devices, can be connected to one Raspberry Pi, although only one microscope can be operated at a time, in the embodiment.

The camera multiplexer board interfaces with the Raspberry Pi through its GPIO pins and CSI port. The communication between the Raspberry Pi and the camera module takes place through the CSI ports, theI2C Interface and the GPIO pins.

By modifying the I2C address of the camera multiplexer board and states of the connected GPIO pins on the Camera Multiplexer board, a different camera can be actively selected by the Raspberry Pi.

The enable pins of the MicroLED boards are connected to separate GPIO pins on the Raspberry Pi essentially allowing us to switch on one MicroLED board at a time.

Hence, by simultaneously switching on one MicroLED board and selecting the respective camera sensor through the Camera multiplexer, followed by the same initialization sequence mentioned in the previous section, a sequence of 128 images can be captured by the Raspberry Pi per microscope. This process can be repeated for all connected microscope for any number of times till the desired number of images are captured.

### VERIFICATION AND TESTS

The primary requirement posed for the microscope of the present embodiment, was NEMUCO-ESR-20 which states the following:
It is required to take phase contrast microscopy images to follow the C2C12 developing myo-tubes/NSC-34 α-motoneurons 3D co-culture developing myotube co-cultures and the time course of the neuro-muscular junction development (synaptogenesis). These shall be taken every two days (nice to have every day) starting at day 0, until the end of the experiment.

The following is required:
- At least 3µg cell co-cultures and at least 3 in-flight 1g control cell co-cultures shall be in-situ observed
- Phase contrast microscopy images shall be taken in the center of the cell culture's surface
- Resolution shall be 3µm or better
- The Field of View (FoV) shall be 30 mm² at 3 µm resolution. The FoV shall correlate with the resolution in a quadratic relationship (linear improvement of the resolution resulting in quadratic reduction of FoV) and can be reduced to a minimum of 10mm² FoV if the resolution is improved accordingly.

### Resolution Target

To quantify the achievable resolution and field of view as well as the phase contrast imaging requirements a phase only resolution target was utilized. This target consists of phase only targets with defined distances and sizes that enable to measure the resolution. As the size of features is known, the actual size of each pixel can be measured based on the target size, and therefore measure the FoV. The utilized target is described in detail in RD21 (RD21: T. M. Godden, A. Muñiz-Piniella, J. D. Claverley, A. Yacoot, and M. J. Humphry, "Phase calibration target for quantitative phase imaging with ptychography," Opt Express, vol. 24, no. 7, p. 7679, Apr. 2016, doi: 10.1364/OE.24.007679.).

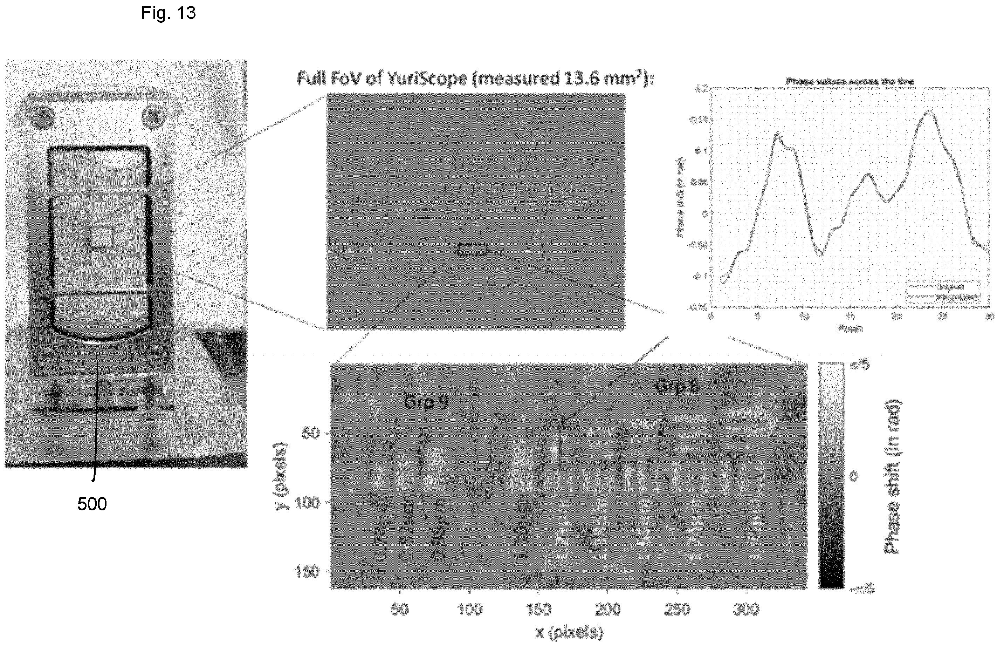

Figure 13 shows the actual FoV of the microscope 100 in relation to the sample on the left side and shows the achieved FoV microscopic image. A zoomed in section of the smaller USAF groups 8 and 9 is also shown to highlight the achieved resolution of 1.23 µm. Across the reference line the phase value of the acquired quantitative phase contrast image was measured and is also shown as plot. As the test shown in Figure 13 resulted in a larger propagation distance and a smaller FoV the test was repeated with the sample oriented towards the camera sensor and a propagation distance of 1.5 mm. In this test a few air bubbles formed and dirt particles are visible in the FoV but the smaller targets of the USAF target Group 8 are visible and confirm a general resolution capability also in this configuration of 1.23 µm.

### NEMUCO Sample

With the NEMUCO sample initial tests were performed using a sample prepared by the PI group using the stepper engine setup. Here a specific ROI can be moved into the image path and therefore easily acquired by the microscope as well. However, the image acquisition differs as only a single LED is utilized an repositioned using stepper engines and no CC is utilized and therefore the proper amount of co-culture medium is also not in the optical path.

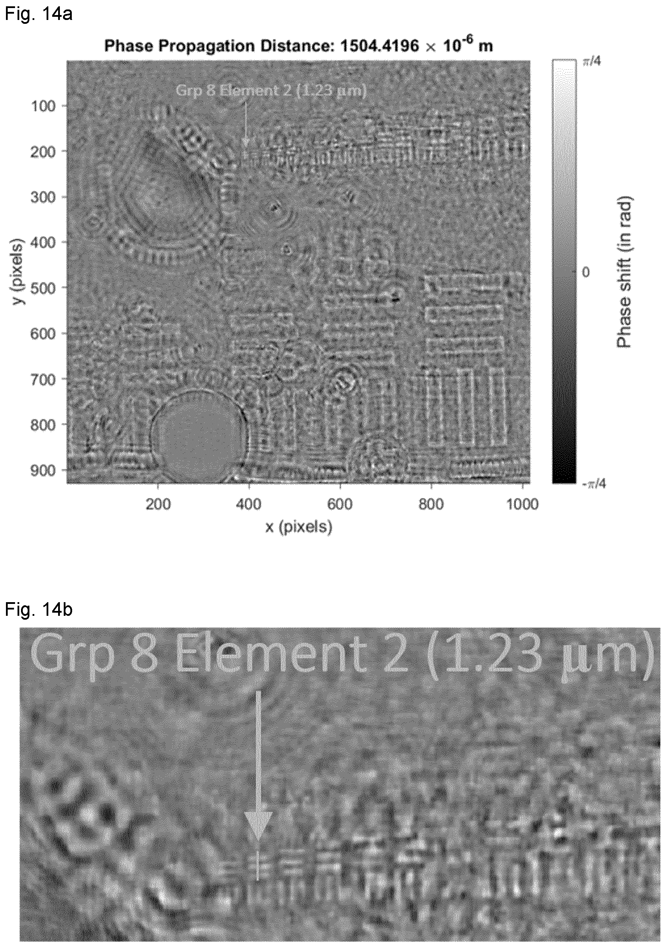

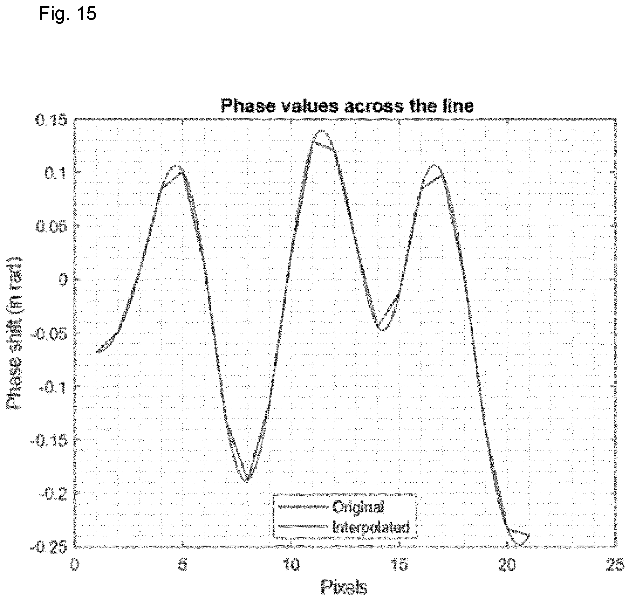

Figure 14a and figure 14b (enlarged detail) show a reference image provided by the PI group on this initial sample and Figure 15 shows a reconstructed image using the stepper based microscope 100 with 27 LEDs. Resolution Target in filled CC with sample oriented towards the camera sensor (1.5 mm distance). Figure 14a shows a part of the FoV with the total FoV measured based on the size of the Resolution Targets to 26.3 mm².

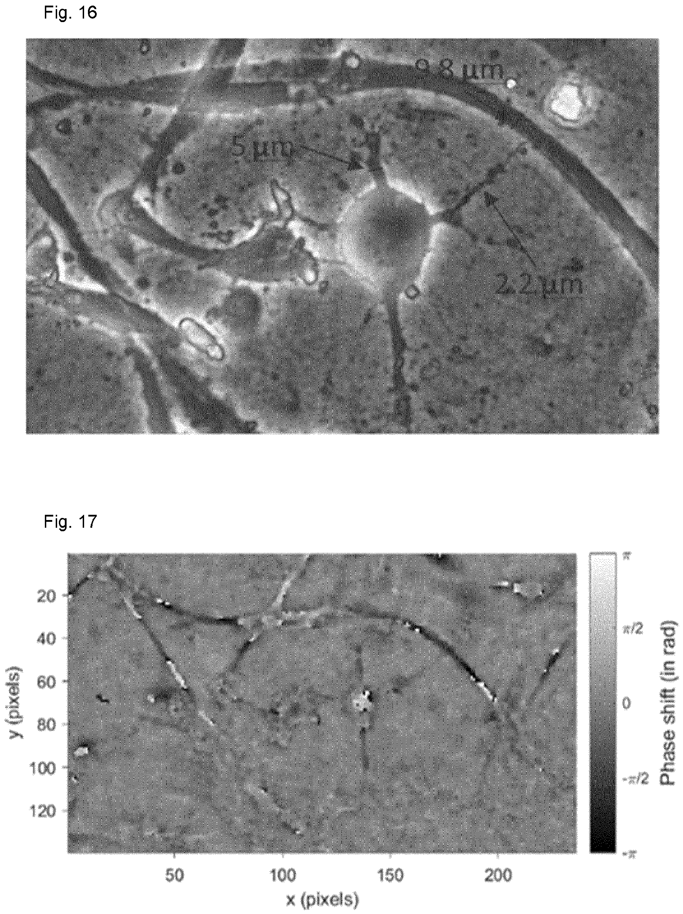

In order to get more representative results, new samples were prepared by the PI group and mounted into the CC which was also filled with co-culture medium (see Figure 16). However, as the polycarbonate slide with the sample is mounted in a fixed position, it is not possible to move the sample to image a specific marked ROI in this case. In addition, all received samples showed significant crystallization already on arrival at the test laboratory, which may impact imaging performance. As Figure 17 shows it was still feasible to achieve a reconstruction showing Myofibers. Fig. 16 shows a reference image acquired by the NEMUCO PI group with primary feature sizes of the cells stated (measured based on the provided scalebar from the PI Group). Figure 17 shows a reconstructed phase contrast image of the same ROI as Figure 16 using 27 images in a cross pattern actuated with stepper engines.

The tests on the phase calibration target confirm that the microscope 100 is able to image the intended cells, and the performed tests also show this capability.

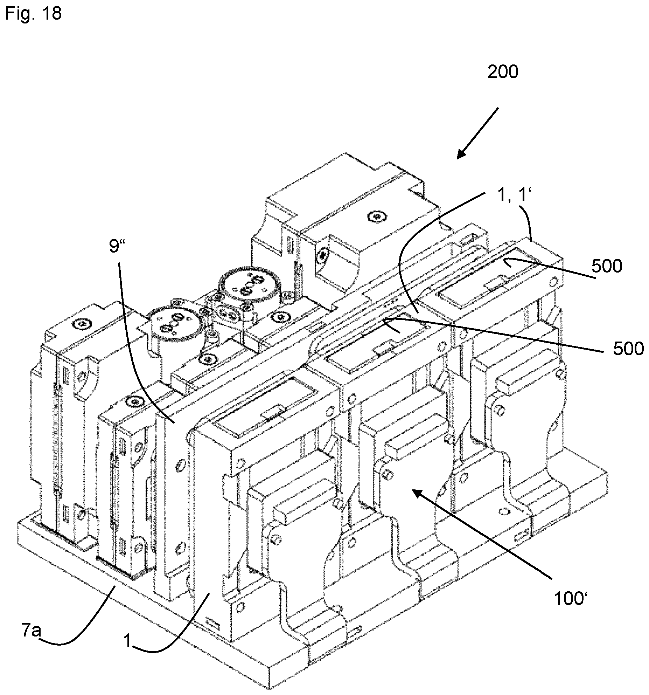

Fig. 18 shows an aerospace experimental module 200 having a payload space, being, in particular, limited to a compact volume, here of between 1 dm3 and 10 dm3, wherein one or more lensless imaging devices 1, 1', and respectively, a microscope 100' according to embodiments is mounted inside the volume of the payload space. Three lensless imaging device 1, 1' are mounted here on a base plate 7a. One electronic board 9" comprises the electronic control devices of the single lensless imaging devices. The electronic board 9" also implements the post-processing method for obtaining the microscopic image (brightfield and phase contrast) from the hologram images obtained by each of the three lensless imaging devices 1, 1'. Therefore, the microscope 100' features three lensless imaging devices 1, 1'. Further components, not described here, are mounted on the base plate 7a.

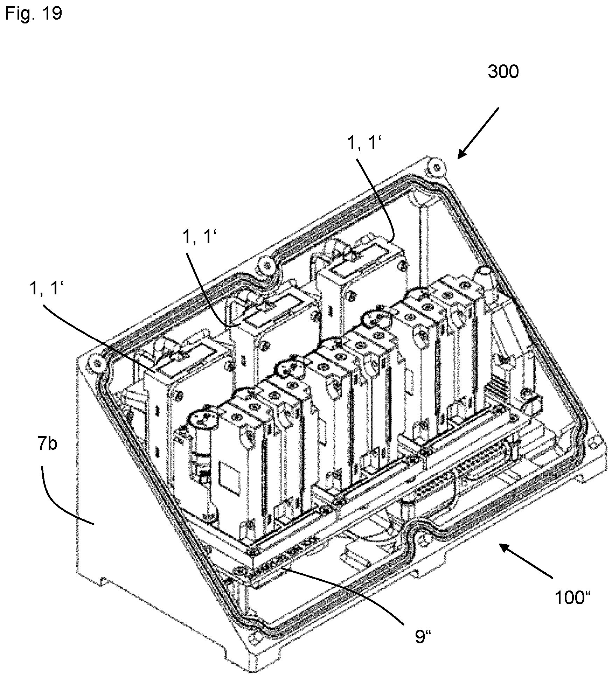

Fig. 19 shows another aerospace experimental module 300 having a payload space, being, in particular, limited to a compact volume, here of between 1 dm3 and 10 dm3, wherein one or more lensless imaging devices 1, 1', and respectively, a microscope 100" according to embodiments is mounted inside the volume of the payload space. Three lensless imaging device 1, 1' are mounted here inside a holding frame 7b. One electronic board 9" comprises the electronic control devices of the single lensless imaging devices. The electronic board 9" also implements the post-processing method for obtaining the microscopic image (brightfield and phase contrast) from the hologram images obtained by each of the three lensless imaging devices 1, 1'. Therefore, the microscope 100" features three lensless imaging devices 1, 1'. Further components, not described here, are mounted on the base plate 7a.

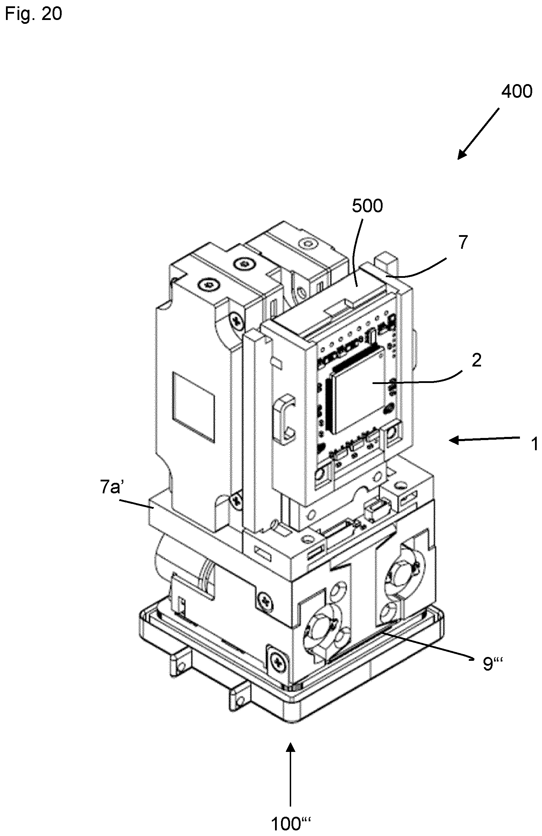

Fig. 20 shows an aerospace experimental module 400 having a payload space, being, in particular, limited to a compact volume, here of 1 dm3, wherein one or more lensless imaging devices 1, 1', and respectively, a microscope 100'" according to embodiments is mounted inside the volume of the payload space. One lensless imaging device 1, 1' is mounted here on a base plate 7a'. One electronic board 9"' comprises the electronic control devices of the single lensless imaging device. The electronic board 9‴ also implements the post-processing method for obtaining the microscopic image (brightfield and phase contrast) from the hologram images obtained by the lensless imaging device 1, 1'. Therefore, the microscope 100'" features one lensless imaging devices 1, 1'. Further components, not described here, are mounted to the base plate 7a', forming a highly integrated apparatus.

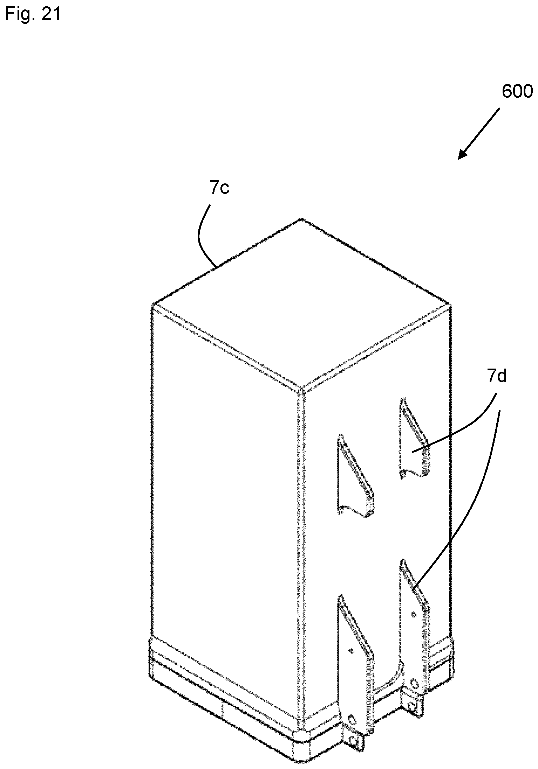

Fig. 21 shows the container 7c, which contains and encloses the aerospace experimental module 400 of Fig. 20. The container features fixation means 7d for mounting the container 7a to a mounting position in a spaceship laboratory, for example within the ISS. The container has an electrical interface (not shown) for powering the microscope 100'" and other electrical components inside the container 7c. The whole object shown in figure 21 is also referred to as container device 600.

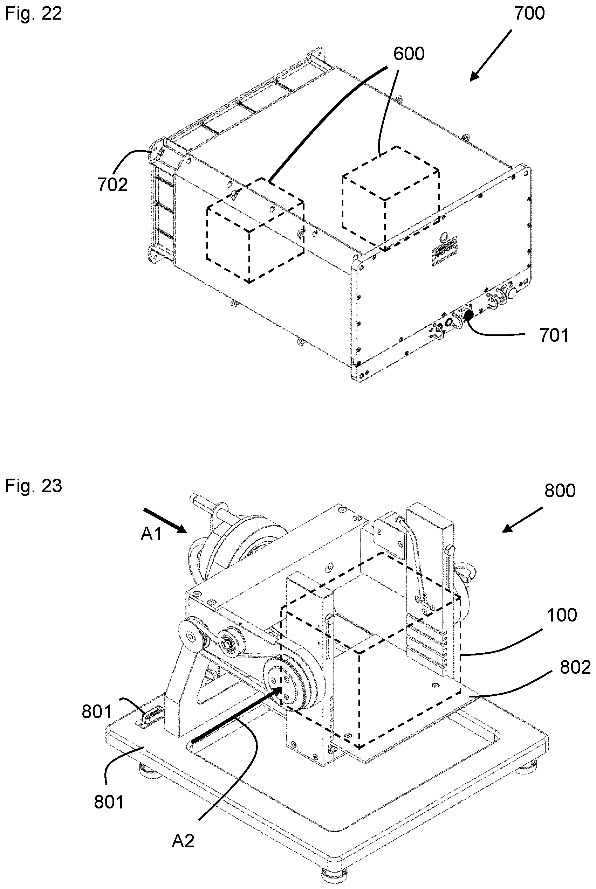

Fig. 22 shows a collective container 700, which is capable to contain multiple aerospace experimental module 300, 400, 600, or respectively, multiple containers 600. A connector device 701 may contain electrical connectors and/or non-electrical connectors for exchange of fluids. The collective container 700 also features fixation means 702 for mounting the container 700 to a mounting position in a spaceship laboratory, for example within the ISS.

Fig. 23 shows a random positioning machine (RPM) 800, to the platform of which a microscope 100 according to the invention can be mounted. A random positioning machine typically consists of a stable base 801 that remains fixed in place, ensuring minimal vibration and a solid foundation for the apparatus. Attached firmly to this base 801 is a structure or part that can rotate about a second axis (A2). This structure provides the support necessary to carry a first axis (A1), which is mounted so that it is perpendicular to A2. The first axis A1 in turn supports a platform 802 designed to hold an experimental module, including the microscope 100. Each axis is equipped with its own drive mechanism, allowing independent rotation. During operation, the platform is reoriented continuously and pseudo-randomly around both A1 and A2, thereby averaging out the local gravitational vector over time. Other modes of motion are possible, for example imitating a one-axis-clinostat. This persistent change of orientation simulates a microgravity environment for the module's contents, often used for biological, microfluidic, or other scientific experiments that benefit from conditions resembling those in low Earth orbit. Electrical connections for powering the microscope 100 may be provided on the platform 802 and be connected to connectors 803 of the base of the RPM. The RPM thereby provides electrical connectivity of the microscope 100 to an external electrical instance.

## Claims

1. Lensless imaging device (1; 1'; 1") for obtaining a hologram image, carrying intensity and phase information, of microbial specimen (99), in particular biological cells, in particular having a maximum measure between 5 and 120 µm, contained in a culture chamber (500; 500'), comprising
• a camera sensor device (2; 2'; 2") having a camera sensor surface (3'),
• a microLED array device (4; 4'; 4") having individually controllable microLEDs (5; 5'), which are aligned along an LED array plane (6; 6');
• a holder device (7; 7'; 7") for maintaining a relative position of the camera sensor device (2; 2') and the microLED array device (4; 4'), creating a receiving space (8; 8') between the camera sensor surface (3; 3') and the LED array plane (6; 6'), which are separated by a first distance (d1),
• the receiving space (8; 8') being adapted to receive the culture chamber (500; 500') and being adapted for allowing the transmission of light, which is emitted by the microLED array device (4; 4'), through the receiving space (8; 8') and the culture chamber (500; 500');
• an electronic control device (9; 9') for controlling the microLED array device (4; 4') and the camera sensor device (2; 2') and being programmed to perform an image capture process for obtaining a hologram image of the microbial specimen (99) contained in the culture chamber (500; 500'); and
• a data storage device (10; 10') for storing hologram image data obtained by the camera sensor device (2; 2'), the hologram image data representing the hologram image.

2. Lensless imaging device according to claim 1, wherein the first distance is between 5,0 mm and 20,0 mm, preferably between 6,0 mm and 15,0 mm, preferably between 8,0 mm and 12,0 mm.

3. Lensless imaging device according to claim 1 or 2, wherein the camera sensor device includes a coded surface arranged on top of the camera sensor surface for allowing retrieval of phase information using coded ptychography or for allowing retrieval of bright field images using coded ptychography.

4. Lensless imaging device according to any of the previous claims, wherein electronic control device is programmed to sequentially obtain a set of N different hologram images, wherein the hologram images were obtained by illuminating a culture surface of the culture chamber using different microLEDs of the microLED array,
wherein, in particular, the culture surface contains an overlapping area, which is imaged by each of the hologram images of the set.

5. Lensless imaging device according to any of the previous claims, wherein the electronic control device is programmed to sequentially obtain a set of hologram images, which are obtained by controlling an individual microLED of the microLED array, the set including, in particular, a first hologram image obtained by illuminating the receiving space using a first microLED and a second hologram image obtained by illuminating the receiving space using a second microLED, which is different from the first microLED. Herein, sequentially obtaining the images means that the microLEDs are activated one after the other, whereby preferably only one microLED is active at a time while the other microLEDs are deactivated, or wherein only a fraction of microLEDs is active at a time while the other microLEDs are deactivated, the fraction containing 2 or more microLEDs, in particular a maximum of 10 LEDs.

6. Lensless imaging device according to claim 5, wherein the microLED array has a LED pitch PL being a center-to-center distance of adjacent microLEDs of the microLED array, and wherein the electronic control device is programmed to obtain a first hologram image obtained by illuminating the receiving space using a first microLED and a second hologram image obtained by illuminating the receiving space using a second microLED, the first microLED being separated from the second microLED by the LED pitch PL.

7. Lensless imaging device according to claim 5 or 6, wherein the total number N of hologram images of the set of hologram images is between 2 <= N <= 200, preferably between 4 <= N <= 100, most preferably between 4 <= N <= 30,
i) and/or wherein, preferably, a width w of the microLED is between 0.5 µm and 10 µm, preferably 0.8 µm <= w <= 8.0 µm, preferably 1.0 µm <= w <= 6.0 µm.
ii) and/or wherein, preferably, an LED pitch PL of the microLED array is chosen from the preferred range 1.0 µm <= PL <= 50 µm, the preferred range 5.0 µm <= PL <= 30 µm, or the preferred range 5.0 µm <= PL <= 12 µm.
iii) and/or wherein, preferably, the microLED array is a complete rectangular array of microLEDs, also referred to as microLED matrix, the microLED matrix having n rows and p columns forming an n × p matrix, having a microLED at each grid point of the matrix, the microLED matrix having an LED pitch PL,
or wherein, preferably, the microLED array is an incomplete rectangular array of microLEDs, the microLED matrix having n rows and p columns forming an n × p matrix, having multiple grid point of the matrix being occupied by a microLED each and having multiple void grid point of the matrix **not** being occupied by a microLED each, the microLED matrix having an LED pitch PL, the void grid points of the matrix providing a space for receiving wiring for powering the microLEDs at the occupied grid points,
wherein in particular, the incomplete rectangular array of microLEDs having microLEDs being arranged in the shape of a cross, or circular, or ellipsoidal ring;
iv) and/or wherein, preferably, the center-to-center distance LDmax of the outermost microLEDs of a row or a column of the microLED matrix is chosen from the preferred range 30.0 µm <= LDmax <= 500 µm, the preferred range 60.0 µm <= LDmax <= 300 µm, the preferred range 100.0 µm <= LDmax <= 200 µm, or the preferred range 120.0 µm <= LDmax <= 160 µm. Herein, in particular, LDmax = n * PL or LOmax = p * PL.
v) and/or wherein, preferably, the lensless imaging device is configured to provide a field of view (FoV) taken from the preferred range 5.0 mm² <= FoV <= 200 mm², the preferred range 5.0 mm² <= FoV <= 100 µm², or the preferred range 10.0 mm² <= FoV <= 35.0 mm².

8. Lensless imaging device according to any of the previous claims, wherein the camera sensor device having a sensor matrix of r x s sensor pixels, having a pixel pitch PS of adjacent sensor pixels being measured center-to-center, r being chosen from the preferred range 1000 <= r <= 6000, s being chosen from the preferred range 1000 <= s <= 8000.

9. Lensless imaging device according to claim 6 and 8, wherein PL > PS, wherein preferably PL = c * PS with preferably c= between 2 and 10, PL being the LED pitch PL of the microLED array, and PS being the sensor pixel pitch of the sensor matrix,
wherein, in particular, the electronic control device is programmed to obtain a first hologram image obtained by illuminating the receiving space using a first microLED and a second hologram image obtained by illuminating the receiving space using a second microLED, the first microLED being separated from the second microLED such that PF is a non-integer multiple of PS, in particular c being non-integer, e.g. c= 2.5.

10. Lensless imaging device according to any of the previous claims, which comprises the culture chamber being inserted in the receiving space in an inserted position of the culture chamber,
the culturing chamber comprising a culture surface for supporting the microbial specimen, and the culture surface being positioned in a second distance d2 to the camera sensor surface and the culture surface being positioned in a third distance d3 to the microLED array device,
wherein, preferably, the third distance is larger than the second distance in the inserted position of the culture chamber, or, preferably, wherein the second distance is equal to or larger than the third distance in the inserted position of the culture chamber,
wherein, in particular, the camera sensor surface may be a coded surface.

11. Lensless imaging device according to claim 10, wherein d3 is taken from the range 5.0 mm to 50.0 mm, preferably 5.0 mm <= d3 <= 20.0 mm, preferably 7.0 mm <= d3 <= 9.0 mm.

12. Microscope system comprising a lensless imaging device according to any of the claims 1 to 11 and a computing device,
the computing device being configured to receive the hologram image data representing the hologram image and the computing device being programmed to execute a post processing method for reconstructing a microscope image of the of microbial specimen contained in the culture chamber from the hologram image data.

13. Microscope system according to claim 12, wherein the post processing method comprises the programmed step of
• performing a phase retrieval method using the hologram image data or brightfield image data of the hologram image for obtaining a phase image of the hologram image in the form of phase image data.

14. Microscope system according to claim 13, wherein the phase retrieval method comprises the programmed step of utilizing multiple shifted hologram images (diffraction patterns) of the microbial specimen contained in the culture chamber, wherein the multiple shifted hologram images were obtained by imaging the multiple hologram images using different positions of illumination, in particular by activating different microLEDs, to reconstruct the phase information.

15. A computer-implemented method of reconstructing a microscope image of microbial specimen contained in the culture chamber from hologram image data obtained by the lensless imaging device according to any of the claims 1 to 11, the hologram image data representing a hologram image.
